# EUROPEAN PATENT SPECIFICATION

(11) **EP 3 347 647 B1**
(45) Date of publication and mention of the grant of the patent: **23.03.2022**
(21) Application number: 16730380.9
(22) Date of filing: 17.06.2016
(51) Int. Cl.: F23C 13/00, H01L 27/30, F23D 14/16, F23D 14/12, F23M 20/00, F23D 14/18, H02S 10/30, H01L 51/44

(54) **THERMOPHOTOVOLTAIC SYSTEM AND ENERGY CONVERSION AND TRANSPARENT TRANSFER MEDIA**
ENERGIEUMWANDLUNG UND TRANSPARENTE ÜBERTRAGUNGSMEDIEN
CONVERSION D'ÉNERGIE DES SUPPORTS DE TRANSFERT TRANSPARENTS

(30) Priority: 19.06.2015 EP 15173005
(43) Date of publication of application: 18.07.2018
(73) Proprietor: Triangle Resource Holding (Switzerland) AG, 6300 Zug (CH)
(72) Inventor: WEIDMANN, Urs, 6330 Cham (CH); HOLZNER, Reto, 8050 Zürich (CH)
(74) Representative: Troesch Scheidegger Werner AG
(86) International application number: PCT/EP2016/064075
(87) International publication number: WO 2016/203012

(56) References cited:
- EP-A1- 2 357 683
- EP-B1- 0 804 809
- WO-A1-2014/086945
- US-A- 4 707 560
- US-A- 4 906 178
- US-A- 5 503 685
- US-A- 5 797 997
- US-A1- 2006 107 995

## Description

### FIELD OF THE INVENTION

The present invention relates to a thermophotovoltaic system and an energy conversion and transfer media, in particular to an energy conversion and transfer fiber. The invention further relates to combustion, heat-exchange and emitter devices as well as thermophotovoltaic devices and systems comprising such an energy conversion and transfer media.

### BACKGROUND OF THE INVENTION

With the high demand of electricity and even more of clean, CO₂ neutral energy sources, the efficiency with which the energy is harvested plays a more and more important role. As gradually many industrialized countries aim for shifting away from nuclear power production, the demand for alternative energy sources is greater than ever. However, so far few if any really viable alternatives are known. Many of the "classical" renewable energy sources such as wind-turbines or solar power plants have significant drawbacks preventing their wide-spreading.

Still, even if these drawbacks of "classical" renewable energy sources such as wind-turbines or solar power plants would be solved, there is still the major problem that quite often these sources of renewable energy are not available at a location and/or time the electrical energy is needed. The great distances between the generation location and the energy consumers require very complex, expensive and environmentally unfriendly infrastructure to transport and store the produced electrical energy. Furthermore, regardless of the improvements of such infrastructures in the latest period, there are still significant losses in the transport of electrical energy over long distances. Therefore there is an urgent need for decentralized energy production. In other words, the future of energy production lies in producing energy as close as possible to the consumer. This not only reduces/ eliminates transmission losses but relives the electrical grid while ensuring much higher levels of flexibility.

One of the fields of great interest for decentralized energy production is the field of thermophotovoltaic devices, devices designed to transform chemical energy stored in a fuel into electro-magnetic radiation and then into electricity. However, the relatively reduced efficiency of the existing thermophotovoltaic devices has limited their use and mass-deployment.

Furthermore there is an increasing demand for mobile energy carriers/ generators, ranging from portable electronic devices to electrically-powered heavy machinery. There is also a need for multi-purpose energy generators, providing for selective or simultaneous generation of heat; and/or light and/or electricity.

As for efficiency, a problematic aspect of these chemical-to-electric energy converters is on one side the inefficiency of the conversion of chemical energy into electro-magnetic radiation and on the other side the inefficiency of the conversion of the electro-magnetic radiation into electricity.

A particularly difficult and so far only partially solved problem is the transfer of electro-magnetic radiation (from where it has been produced by conversion of chemical energy) to the harvesting point thereof, i.e. where the conversion of the electro-magnetic radiation into electricity is performed.

US 5'503'685 A discloses a photon generating device with a light pipe, wherein the thermal input of the device is provided from combustion. US 4'906'178 A discloses gas-fired appliance with an intermittent ignition.

The objective of the present invention is thus to provide an energy conversion and transfer media which on one hand provides an efficient conversion of chemical energy into electro-magnetic radiation and on the other hand enables an efficient transfer of said electro-magnetic radiation to the point of conversion thereof into electricity (usually a photovoltaic cell).

A further objective of the present invention is to provide a thermophotovoltaic device comprising such an energy conversion and transfer media, in particular energy conversion and transfer device.

An even further objective of the present invention is to provide a thermophotovoltaic system for selective and/or simultaneous generation of electricity, heat, light and drinkable water.

### SUMMARY OF THE INVENTION

The invention involves a thermophotovoltaic system according to claim 1. The above-identified objectives of the present invention are solved by such a thermophotovoltaic system. The preferred embodiments are set out in the appended set of dependent claims.

The invention involves a thermophotovoltaic system comprising:
- a heat transfer chamber, and
- at least one energy conversion and transfer media, which comprises:
- a transparent core for energy transfer and
- a selective emitter material configured for emitting predominantly near-infrared radiation when heated up to high temperatures, wherein the transparent core is doped with said selective emitter material and/or the energy conversion and transfer media comprises a, in particular tubular, radiation emitter doped with said selective emitter material, wherein the transparent core is arranged within said radiation emitter and/or between at least two separate parts of said radiation emitter,
the at least one energy conversion and transfer media being arranged within said heat transfer chamber and being coupled, preferably butt-coupled, to at least one photovoltaic cell and/or comprising at least one photovoltaic section that is configured to convert the radiation emitted by the radiation emitter into electricity,
the thermophotovoltaic system further comprising a fuel source for performing a combustion process in said heat transfer chamber,
wherein the thermophotovoltaic system is configured to perform the combustion process as a pulsed combustion.

In one example the energy conversion and transfer media comprises a transparent core for energy transfer, preferably an optical fiber and/or a glass rod, and a selective emitter material configured for emitting predominantly near-infrared radiation when heated up to high temperatures. The transparent core is doped with said selective emitter material and/or the energy conversion and transfer media comprises a, in particular tubular, radiation emitter that is doped with the selective emitter material. In the latter case, the transparent core is arranged within the radiation emitter and/or between at least two separate parts of the radiation emitter.

In one example the energy conversion and transfer media comprises a, in particular tubular, radiation emitter for energy conversion doped with a selective emitter material configured for emitting predominantly near-infrared radiation when heated up to high temperatures, wherein a catalytic section of an outer surface of said radiation emitter is at least partially provided with a catalytic coating in order to maximize heat transfer between a chemical energy carrier (fuel) and said catalytic section of the radiation emitter and/or to provide surface reactions causing e.g. candoluminescence. The energy conversion and transfer media further comprises a core for energy transfer, preferably an optical fiber and/or a transparent core, further in particular a glass rod, arranged adjacent to the radiation emitter, in particular within said radiation emitter and/or between at least two separate parts of the radiation emitter. The electromagnetic radiation is therefore transferrable within the energy conversion and transfer media, in particular fiber, in an efficient manner similar to how light is transmitted within an optical fiber. Candoluminescence is an observable effect that materials behave differently when heated in a flame, which is in contrast to a heating in an electric oven.

In one example the thermophotovoltaic system comprises a heat transfer chamber and at least one energy conversion and transfer media, which comprises a transparent core for energy transfer and a selective emitter material configured for emitting predominantly near-infrared radiation when heated up to high temperatures. The transparent core is doped with the selective emitter material and/or the energy conversion and transfer media comprises a, in particular tubular, radiation emitter doped with the selective emitter material, wherein the transparent core is arranged within the radiation emitter and/or between at least two separate parts of the radiation emitter. The at least one energy conversion and transfer media is arranged within the heat transfer chamber and is coupled, preferably butt-coupled, to at least one photovoltaic cell and/or comprises at least one photovoltaic section that is configured to convert the radiation emitted by the radiation emitter into electricity. The thermophotovoltaic system further comprises a fuel source for performing a combustion process in the heat transfer chamber, wherein the thermophotovoltaic system is configured to perform the combustion process as a pulsed combustion. This way, the electrical power output resulting from the pulsed combustion can on the one hand be provided instantaneously and on the other hand the repetition rate, in particular the pulse repetition rate (PRR), can be varied continuously with unchanged efficiency over the entire power range, practically without delay.

The expression "pulsed combustion" or "combustion in a pulsed manner" refers to an intermittent and/or pulsed shaped combustion process. For example, the pulsed combustion is achieved by feeding a fuel, for example methanol, in an intermittent and/or pulse-shaped manner. In another example, which can be combined with the previous example, the pulsed combustion is achieved by adding oxygen in an intermittent and/or pulse-shaped manner to a previously fed fuel. The term "intermittent" refers an interrupt action with pauses between two actions and the term "pulse-shaped" refers to a distinct step between a first state (which may or may not be a pause of action) and a further state.

With the pulsed combustion fast reactions, for example an immediate switch-on or switch-off, can be achieved, which is particular useful in case of a power breakdown. In one example, a switch-on and/or a switch-off time of a fraction of a second, e.g. less than 0.5 s, can be achieved.

The pulsed combustion provides the possibility to adapt the process parameters in order to achieve the optimum balance between power production and heat production according to the current conditions and/or requirements. For example, a faster pulse repetition rate (PRR) leads to a higher fuel consumption and produces a higher electrical output power, but also a higher thermal power at the cost of a lower electrical efficiency. The best electrical efficiency is achieved by adapting the PRR as slow as possible, because the exiting exhaust gases at the end of the pulse the having the lowest temperature.

Further, the pulsed combustion has a positive effect on the stability of materials used, in particular the suppression of crystallization processes by amorphization (for example cristobalite in silica).

In addition, the intermittent and/or pulsed combustion also enables to exploit thermal imbalances, which for example relate to the so-called candoluminescence. This candoluminescence results from short-term increased temperatures and/or an energy transfer by free radicals. These thermal imbalances allow to achieve an improved efficiency.

In an embodiment of the invention a catalytic section of an outer surface of the energy conversion and transfer media, in particular of the radiation emitter, is arranged within the heat transfer chamber and/or is at least partially provided with a catalytic coating in order to maximize heat transfer between a chemical energy carrier and the catalytic section and/or to provide surface reactions, which in particular cause candoluminescence.

In a further embodiment of the invention, the energy conversion and transfer media is configured as an optical fiber and/or an optical rod such as a glass rod, wherein in particular the radiation emitter has an index of refraction lower than the transparent core, so as to provide for an internal reflection, preferably total internal reflection, of radiation within the transparent core so as to thereby confine the radiation therein.

In a further embodiment of the invention, a spectral shaper is provided between the radiation emitter and the transparent core, wherein the spectral shaper is configured as:
- a band pass filter for a first, optimal spectral band of the radiation emitted by the radiation emitter when exposed to high temperature; and/or
- a reflector for further, non-optimal spectral band(s) of the radiation emitted by the radiation emitter, so that the second, non-optimal spectral band radiation is recycled as radiation redirected towards the radiation emitter.

In a further embodiment of the invention, the transparent core is made of a material such as SiO2, YAG (Yttrium Aluminum Garnet) or Yb and/or the transparent core and/or the radiation emitter is doped with a rare earth containing material, preferably with Ytterbium containing material, further in particular with Ytterbium-oxide Yb2O3.

In a further embodiment of the invention, the at least one photovoltaic section is a fiber section and/or is provided in a section of the energy conversion and transfer media other than a catalytic section.

In a further embodiment of the invention, the thermophotovoltaic system further comprises a thermophotovoltaic device for converting chemical energy into electricity, the thermophotovoltaic device having a combustion, heat-exchange and emitter device for converting chemical energy into electro-magnetic radiation. The combustion, heat-exchange and emitter device, which comprises the chamber enclosure and the at least one energy conversion and transfer media and/or the at least one photovoltaic cell or photovoltaic section.

In a further embodiment of the invention according to the previous embodiment, along the photovoltaic section(s):
- the transparent core is longitudinally surrounded by a radiation transmissive first, in particular tubular, electrode;
- the first electrode is covered, in particular longitudinally surrounded, by a photosensitive layer; and
- the photosensitive layer is covered, in particular longitudinally surrounded, by a second, in particular tubular, electrode.

In a further embodiment of the invention according to the previous embodiment, within the photovoltaic section(s):
- a radiation transmissive first, in particular disc-like, electrode is arranged, in particular axially, adjacent to the transparent core;
- a photosensitive element, in particular a photosensitive disk, is arranged, in particular axially, adjacent to the first electrode; and
- a second, in particular disc-like, electrode is arranged, in particular axially, adjacent to the photosensitive element.

In a further embodiment of the invention, the transparent core is operationally connected to a bragg filter, in particular a bragg gating and/or bragg fibre filter, for a selectively decoupling of the emitted predominantly near-infrared radiation, in particular a radiation with a wavelength λ in a range from 0.5 µm to 1.5 µm, in particular of approximately 1 µm.

In a further example the heat transfer chamber is a closed or a flow-through heat transfer chamber and/or the thermophotovoltaic system comprises a chamber enclosure that defines the heat transfer chamber, wherein the chamber enclosure is preferably made of a high temperature resistant material such as a ceramic material.

In a further example, a bundle of the energy conversion and transfer media is arranged, in particular arranged with their corresponding catalytic section(s), within the heat transfer chamber, in particular arranged such as to optimize catalytic combustion on the catalytic section(s) of a fuel provided within the heat transfer chamber.

In a further embodiment of the invention, the thermophotovoltaic system is configured to perform an isochoric and/or adiabatic combustion and/or configured to feed oxygen, in particular heated oxygen, into the heat transfer chamber in an intermittent and/or pulse-shaped manner.

In a further embodiment of the invention, the thermophotovoltaic system comprises a fuel source, arranged such as to direct a combustible fuel mixture from the fuel source towards the heat transfer chamber, wherein in particular the fuel source is a chemical energy source, wherein the chemical energy carrier is a fossil or synthetic fuel such as Methanol and/or the fuel source is configured to feed the fuel in an intermittent and/or pulse-shaped.

In a further example, the thermophotovoltaic system further comprises a waste heat recovery unit configured to recover heat from exhaust gases at an exhaust side of the heat transfer chamber and feed back the recovered heat to an input side thereof or to forward the recovered heat to an external waste heat recovery.

In a further embodiment of the invention, the thermophotovoltaic system is configured as a portable energy source such as to simultaneously or selectively:
- act as a heat source providing heat radiation from the thermal energy source and/or the heat transfer chamber and/or;
- act as a source of electric energy providing electric energy;
- act as a light source at a distal end(s) of the at least one of energy conversion and transfer media, the radiation emitter being configured such as to provide electro-magnetic radiation also in the visible spectrum when exposed to high temperature.

In a further example, the thermophotovoltaic system further comprises a condenser unit configured to recover liquid by condensing vapour in exhaust gases at an exhaust side of the heat transfer chamber, preferably condensing water vapours resulting from combustion of Methanol as fuel, the thermophotovoltaic system thus being further configured as a source of pure water.

Further, the invention involves a modular system that comprises a plurality of modules, each comprises the thermophotovoltaic system according to any one of the preceding embodiments, wherein in particular the modules are interconnected via at least one of:
- a photovoltaic cell,
- a first inlet,
- a second inlet,
- an igniter, and
- an exhaust.
- an exhaust.

In one example, the pulsed combustion takes place in each module of the thermophotovoltaic system, which in particular is individually controlled and/or by a pulsed adding of oxygen to a previously fed fuel such as a previously fed methanol.

In one example the energy conversion and transfer media comprises a transparent core for energy transfer, preferably an optical fiber and/or a glass rod, and a selective emitter material configured for emitting predominantly near-infrared radiation when heated up to high temperatures. The transparent core is doped with said selective emitter material and/or the energy conversion and transfer media comprises a, in particular tubular, radiation emitter that is doped with the selective emitter material, wherein the transparent core is arranged within the radiation emitter and/or between at least two separate parts of the radiation emitter. As explained further below, high localized temperatures can be achieved this way.

The energy conversion and transfer media, in particular the energy conversion and transfer fiber, therefore resembles an optical fiber with the difference that electromagnetic radiation is generated therein as opposed to being introduced from an external source.

In one example the combustion, heat-exchange and emitter device converts chemical energy into electro-magnetic radiation, the device comprising a chamber enclosure, preferably made of a high temperature resistant material such as a ceramic material, the chamber enclosure defining a heat transfer chamber, in particular a flow through or a closed heat transfer chamber. The device further comprises the energy conversion and transfer media, in particular at least one energy conversion and transfer fiber, arranged with its/their corresponding catalytic section(s) within said heat transfer chamber. Feeding of the chamber with fuel and and/or other chemical reactants can be continuous or intermittent.

In one example the energy conversion and transfer media comprises a transparent core for energy transfer, preferably an optical fiber and/or a glass rod, and a selective emitter material configured for emitting predominantly near-infrared radiation when heated up to high temperatures. Further, a catalytic section of an outer surface of said an energy conversion and transfer media is at least partially provided with a catalytic coating in order to maximize heat transfer between a chemical energy carrier (fuel) and said catalytic section and/or to provide surface reactions, which in particular cause candoluminescence.

In one example the thermophotovoltaic system comprises such a thermophotovoltaic device and a fuel source arranged such as to direct a combustible fuel mixture from the fuel source towards an input side of the heat transfer chamber.

The most important advantage of the present invention is that it achieves a very high efficiency by optimizing multiple stages of the energy conversion to minimize losses in each stage:
I) Conversion of chemical energy into thermal radiation:
   By concentrating the combustion process of the chemical energy carrier (fuel) to the surface of the catalytic section of the radiation emitter of the transparent media, in particular the energy conversion and transfer fiber, and / or suppressing the combustion reactions in the gas phase, the heat and thus energy transfer between the fuel and the radiation emitter is maximized while heat losses as exhaust gases are minimized;
II) Conversion of thermal energy into electro-magnetic radiation:
   By the use of an appropriate selective emitter material configured for emitting predominantly near-infrared radiation, the amount of thermal energy transformed into electro-magnetic radiation is maximized;
III) Transfer of electro-magnetic radiation:
   By achieving transfer of the electro-magnetic radiation within the energy conversion and transfer media itself, in particular within the energy conversion and transfer fiber, the losses therein are minimized due to the efficiency of the optical structure, in particular the optical-fiber-like structure;
IV) Allowing for pulsed operation e.g. in the case of a closed heat transfer chamber in order to instantaneously control the energy production and conversion processes precisely in time and power.

In one example, the transparent core is an optical transmission element that is operationally connected to the radiation emitter for receiving the predominantly near-infrared radiation and/or that is configured to forward the predominantly near-infrared radiation to an external target, in particular to a photovoltaic cell.

In a further example, a catalytic section of an outer surface of said energy conversion and transfer media, in particular of the radiation emitter, is at least partially provided with a catalytic coating in order to maximize heat transfer between a chemical energy carrier (fuel) and said catalytic section and/or to provide surface reactions, which in particular cause candoluminescence. This is way high localized temperatures can be achieved.

The phenomena of candoluminescence is particular advantageous, because this allows to operate the process in a thermal non-equilibrium state, which in turn allows to increase the peak temperature of the process without significantly increasing the average process temperature. This way a particular high conversation efficiency is achieved.

In a further example, the energy conversion and transfer media is configured as an optical fiber, in particular the radiation emitter has an index of refraction lower than the transparent core, so as to provide for an internal reflection, preferably total internal reflection, of radiation within the transparent core so as to thereby confine the radiation therein.

In a further example, a spectral shaper is provided between the radiation emitter and the transparent core, wherein the spectral shaper:
- is configured as a band pass filter for a first, optimal spectral band of the radiation emitted by the radiation emitter when exposed to high temperature; and/or
- is configured as a reflector for further, non-optimal spectral band(s) of the radiation emitted by the radiation emitter, so that the second, non-optimal spectral band radiation is recycled as radiation redirected towards the radiation emitter.

In a further example, the transparent core is made of a material such as SiO2, YAG (Yttrium Aluminum Garnet) or Yb and/or the transparent core and/or the radiation emitter is doped with a rare earth containing material, preferably with Ytterbium containing material, further in particular with Ytterbium-oxide Yb₂O₃.

In a further example, the energy conversion and transfer media comprises a photovoltaic section(s), in particular a fiber section(s), configured to convert the radiation emitted by the radiation emitter into electricity.

In a further example, the photovoltaic section(s) is/are provided in a section(s) of the energy conversion and transfer media other than the catalytic section.

In a further example, along the photovoltaic section(s):
- the core is longitudinally surrounded by a radiation transmissive first, in particular tubular, electrode;
- the first tubular electrode is covered, in particular longitudinally surrounded, by a photosensitive layer; and
- the photosensitive layer is covered, in particular longitudinally surrounded, by a second, in particular tubular, electrode.

In a further example, within the photovoltaic section(s):
- a radiation transmissive first, in particular disc-like, electrode is arranged, in particular axially, adjacent to the transparent core;
- a photosensitive element, in particular photosensitive disk, is arranged, in particular axially, adjacent to the first electrode; and
- a second, in particular disc-like, electrode is arranged, in particular axially, adjacent to the photosensitive element.

In a further example, the transparent core is operationally connected to a bragg filter in particular a bragg grating and/or bragg fiber filter for a selectively decoupling of the emitted predominantly near-infrared radiation, in particular a radiation with a wavelength λ in a range of 0.5 µm to 1.5 µm, in particular of approximately 1 µm.

Further, an example concerns a combustion, heat-exchange and emitter device for converting chemical energy into electro-magnetic radiation, wherein the device comprises:
- a chamber enclosure, preferably made of a high temperature resistant material such as a ceramic material, the chamber enclosure defining a heat transfer chamber;
- at least one energy conversion and transfer media according to one of the preceding embodiments, arranged, in particular with its/their corresponding catalytic section(s), within the heat transfer chamber.

In a further example according to the preceding example, a bundle of the energy conversion and transfer media is arranged, in particular with their corresponding catalytic section(s), within the heat transfer chamber, in particular arranged such as to optimize catalytic combustion, in particular on the catalytic section(s), of a fuel provided within the heat transfer chamber.

Further, the thermophotovoltaic system concerns a thermophotovoltaic device for converting chemical energy into electricity, having a combustion, heat-exchange and emitter device according to one of the two preceding embodiments, wherein at least one photovoltaic cell is coupled, preferably butt-coupled, with the at least one energy conversion and transfer media, or the photovoltaic fiber section(s) of the at least one energy conversion and transfer media is/are provided for converting the radiation emitted by the corresponding radiation emitter into electricity.

In a further example the thermophotovoltaic system comprises:
- a thermophotovoltaic device according to the preceding embodiments;
- a fuel source, arranged such as to direct a combustible fuel mixture from the fuel source towards the heat transfer chamber.

In a further example of the preceding example, the fuel source is a chemical energy source, wherein the chemical energy carrier is a fossil or synthetic fuel such as Methanol and/or said fuel source is configured to feed the fuel in an intermittent and/or pulse-shaped manner. The intermittent and/or pulse-shaped fuel and/or oxygen feeding allows for instant power control.

In a further example of the preceding thermophotovoltaic system example, the thermophotovoltaic system further comprises a waste heat recovery unit configured to recover heat from exhaust gases at an exhaust side of the heat transfer chamber and feedback the recovered heat to an input side thereof or to forward the recovered heat to an external waste heat recovery.

In a further example of the preceding thermophotovoltaic system example, the system is configured as a portable energy source such as to simultaneously or selectively:
- act as a heat source providing heat radiation from the thermal energy source and/or the heat transfer chamber and/or;
- act as a source of electric energy providing electric energy;
- act as a light source at a distal end(s) of the at least one of energy conversion and transfer media, the radiation emitter being configured such as to provide electro-magnetic radiation also in the visible spectrum when exposed to high temperature.

In a further example of the of thermophotovoltaic system according to the preceding example, the thermophotovoltaic system further comprises a condenser unit configured to recover liquid by condensing vapour in exhaust gases at an exhaust side of the heat transfer chamber, preferably condensing water vapours resulting from combustion of Methanol as fuel, the thermophotovoltaic system thus being further configured as a source of pure water.

A further example involves an energy conversion and transfer media, which can be combined with any of the preceding examples or embodiments and which comprises:
a transparent core for energy transfer, preferably an optical fiber and/or a glass rod; and
a selective emitter material configured for emitting predominantly near-infrared radiation when heated up to high temperatures. This energy conversion and transfer media can be combined with any of the above-mentioned embodiments or combinations thereof.

One example involves a modular system comprising a plurality of modules, each comprising at least one of:
- the combustion, heat-exchange and emitter device according to one of the preceding combustion, heat-exchange and emitter device embodiments,
- the thermophotovoltaic device according to the preceding thermophotovoltaic device embodiment, and
- the thermophotovoltaic system according to any one of the preceding thermophotovoltaic system embodiments,
wherein in particular the modules are interconnected via at least one of:
- a photovoltaic cell,
- a first inlet,
- a second inlet,
- an igniter, and
- an exhaust.

### BRIEF DESCRIPTION OF THE DRAWINGS

Further characteristics and advantages of the invention will in the following be described in detail by means of the description and by making reference to the drawings. Which show:
- Fig. 1A: a perspective top view of an energy conversion and transfer fiber according to the present invention;
- Fig. 1B: a perspective cross section of the energy conversion and transfer fiber according to the present invention;
- Fig. 1C: a partial frontal cross section of the energy conversion and transfer fiber according to the present invention;
- Fig. 2: a perspective cross section of a photovoltaic fiber section of a preferred embodiment of the energy conversion and transfer fiber according to the present invention;
- Fig. 3: a perspective cross section of the photovoltaic fiber section of a further embodiment of the energy conversion and transfer fiber according to the present invention;
- Fig. 4: a perspective cross section of a combustion, heat-exchange and emitter device for converting chemical energy into electromagnetic radiation according to the present invention, having an energy conversion and transfer fiber within a chamber enclosure;
- Fig. 5: a perspective view of a combustion, heat-exchange and emitter device for converting chemical energy into electro-magnetic radiation according to the present invention, having a plurality of bundles of energy conversion and transfer fibers within a chamber enclosure, each fiber comprising a photovoltaic fiber section;
- Fig. 6: a perspective view of a combustion, heat-exchange and emitter device for converting chemical energy into electro-magnetic radiation according to the present invention, having a plurality of bundles of energy conversion and transfer fibers within a chamber enclosure, a single photovoltaic cell being butt-coupled with all the fibers;
- Fig. 7: a perspective view of a thermophotovoltaic system according to the present invention, comprising a thermophotovoltaic device and a fuel source and configured to act as a heat/ electric energy/ light/ clean water source;
- Fig. 8: a schematic view of a thermophotovoltaic system according to the present invention with two bragg gratings for a selectively decoupling 1 µm radiation;
- Fig. 9: a perspective view of a modular system 400 with 4 modules, each comprising a thermophotovoltaic system according to Fig. 8;
- Fig. 10: a diagram showing a spectrum of near-infrared radiation of Yb₂O₃ and a "black body";
- Fig. 11: a diagram showing the relative emissivity of a selective emitter in dependence of wavelength;
- Fig. 12: a schematically simplified detail view 7 of the energy conversion and transfer media according to Fig.8 with doped light guide C and undoped light guide A;
- Fig. 13: a detail view of the energy conversion and transfer media according to Fig. 12, the light guide A being coated with a catalytic coating B;
- Fig. 14: a detail view of the energy conversion and transfer media according to Fig. 12, the doped light guide C being a hollow body;Fig. 15a detail view of the energy conversion and transfer media according to Fig. 14, the undoped light guide A being a hollow body;
- Fig. 16: a detail view of the energy conversion and transfer media according to Fig. 14, the light guide C being coated with the catalytic coating B;
- Fig. 17: a detail view of the energy conversion and transfer media according to Fig. 15, the light guide C being coated with the catalytic coating B;
- Fig. 18: a schematic view of a thermophotovoltaic system according to the present invention with two modules arranged side by side to each other;
- Fig. 19: a schematically simplified cross section view of the core of energy conversion and transfer media according to the invention, the core being a cylindrical solid fiber;
- Fig. 20: a cross section view of the core according to Fig. 19, the core being a cylindrical hollow fiber;
- Fig. 21: a cross section view of the core according to Fig. 19, the core having a rectangular cross section and/or being a plate;
- Fig. 22: a cross section view of the core according to Fig. 21, the core being a hollow glass pipe with rectangular cross section;
- Fig. 23: a cross section view of the core according to Fig. 19 with an arbitrary cross section and made of homogeneous or inhomogeneous material;
- Fig. 24: a cross section view of a core according to Fig. 19 with an arbitrary cross section and made of multiple homogeneous or inhomogeneous materials, with or without hollow spaces;
- Fig. 25: a schematically simplified view of the core of the energy conversion and transfer media according to the invention, the core being homogeneous and/or uniform in axial direction; and
- Fig. 26: a view of the core according to Fig. 25, but the core being an arbitrary periodic, aperiodic, curved, concave or convex structure;
- Fig. 27: a diagram showing the time dependency of light power and heat dissipation of the thermophotovoltaic system according to the invention;
- Fig. 28: a diagram showing the dependency of efficiency from the k-value of the heat transfer chamber;
- Fig. 29: a schematically simplified block diagram of the thermophotovoltaic system according to the invention;
- Fig. 30: a diagram showing the pressure and temperature profile of an Otto motor;
- Fig. 31: a diagram showing the time dependency of radiation emission and fuel injection of the thermophotovoltaic system according to the invention operated at a low pulse repetition rate; and
- Fig. 32: the diagram according to Fig. 31, but operated at a high pulse repetition rate.
Note: The figures are not drawn to scale, are provided as illustration only and serve only for better understanding but not for defining the scope of the invention. No limitations of any features of the invention should be implied form these figures.

### DESCRIPTION OF EMBODIMENTS

Certain terms will be used in this patent application, the formulation of which should not be interpreted to be limited by the specific term chosen, but as to relate to the general concept behind the specific term.

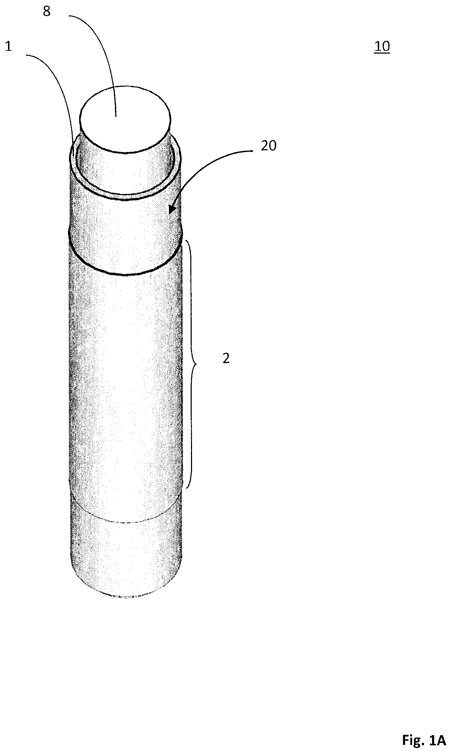

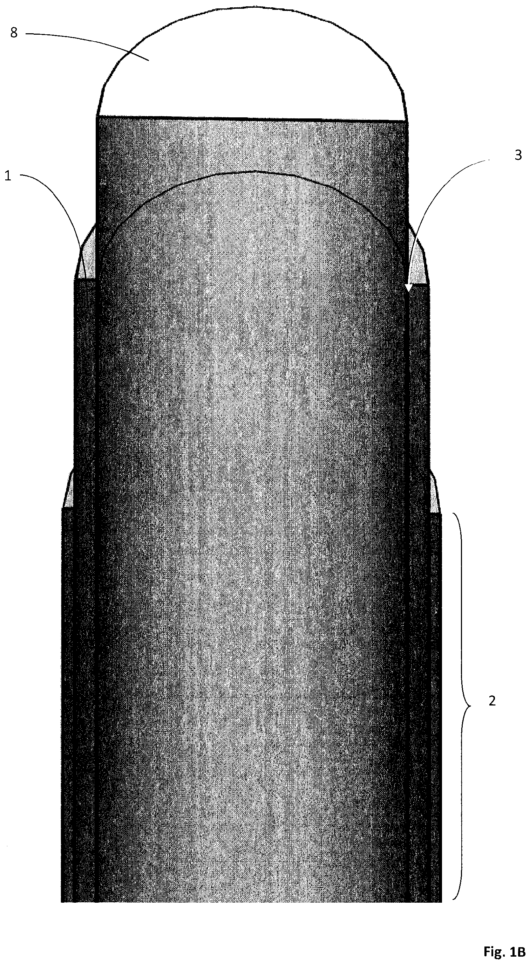

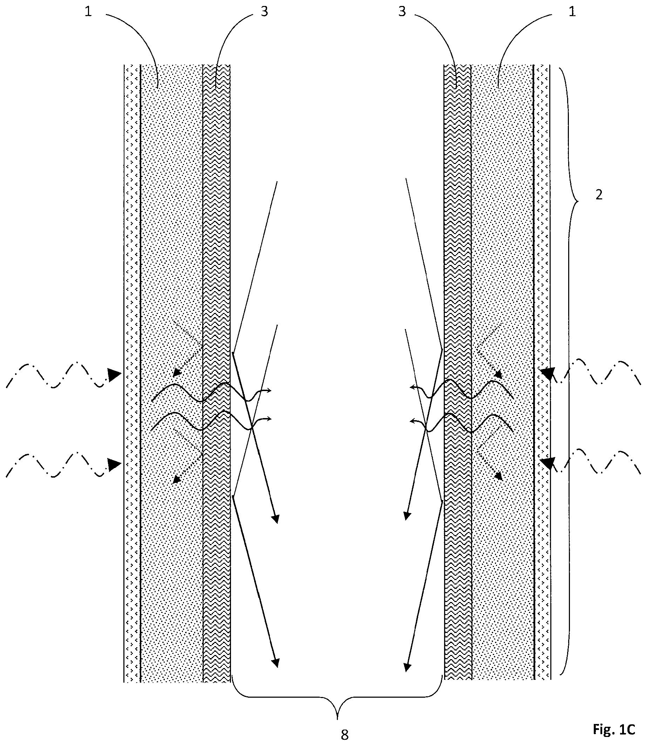

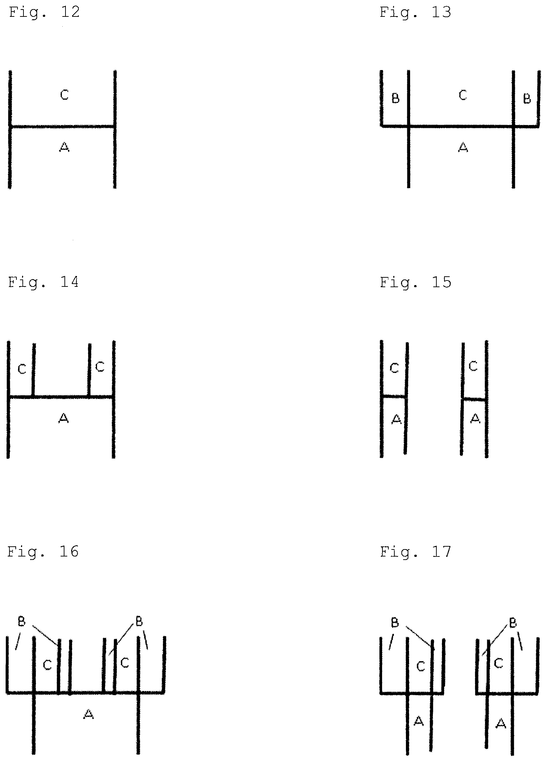

In the descriptions of Fig. 1 to 12 the energy conversion and transfer media according to the invention energy conversion is named "energy conversion and transfer fiber" or simply fiber. Depending on the embodiment, the fiber is filled or tube-shaped. On the other hand, Fig. 13 shows the energy conversion and transfer media according to the invention as a cuboid that comprises an intermediate core arranged between two separate, parallel plates.

While the figures only show cylindrical embodiments of the energy conversion and transfer fiber 10, tubes with other cross-sections (such as rectangular or hexagonal tubes) are also within the scope of the present invention. In this example, the transfer fiber 10 comprises a transparent core 8 and a radiation emitter 1, which is configured as a tubular radiation emitter 1.

Turning now to figures 1A and 1B showing a perspective top view respectively cross section of an energy conversion and transfer fiber 10 according to the present invention, the main structural and functional elements thereof shall be described. The fiber 10 is configured as an optical fiber-like structure having a tubular radiation emitter 1 and a transparent core 8 arranged within said tubular radiation emitter 1.

The tubular radiation emitter 1 is doped with a selective emitter material configured for emitting predominantly near-infrared radiation when heated up to high temperatures. The selective emitter material is one or a combination of rare-earth containing materials, preferably an Ytterbium-oxide Yb₂O₃ or Platinum.

In order to maximize heat transfer with a chemical energy carrier (fuel) by concentrating the combustion process of the chemical energy carrier to its surface, the catalytic section 2 of an outer surface of said tubular radiation emitter 1 is at least partially provided with a catalytic coating.

The core 8 is preferably made of a material such as SiO2, YAG (Yttrium Aluminum Garnet) or Ytterbium (Yb).

As shown on Fig. 1B, a spectral shaper 3 may be provided between the tubular radiation emitter 1 and the core 8, preferably essentially along said catalytic section 2. The spectral shaper 3 has the following functions:
- Act as a band pass filter for a first, optimal spectral band of the radiation emitted by the tubular radiation emitter 1 when exposed to high temperature. This is illustrated in the figures with wave-shaped arrows with continuous lines;
- Act as a reflector for further, non-optimal spectral band(s) of the radiation emitted by the tubular radiation emitter 1, so that said second, non-optimal spectral band radiation is recycled as radiation redirected towards the tubular radiation emitter 1. This is illustrated in the figures with arrows drawn with dotted-lines

As depicted on Fig. 1C showing a partial frontal cross section of the energy conversion and transfer fiber 10 according to the present invention the energy conversion and transfer fiber 10 is configured as an optical fiber, the tubular radiation emitter 1 having an index of refraction lower than the transparent core 8, so as to provide for an internal reflection, preferably total internal reflection, of radiation within the core 8 so as to thereby confine said radiation therein.

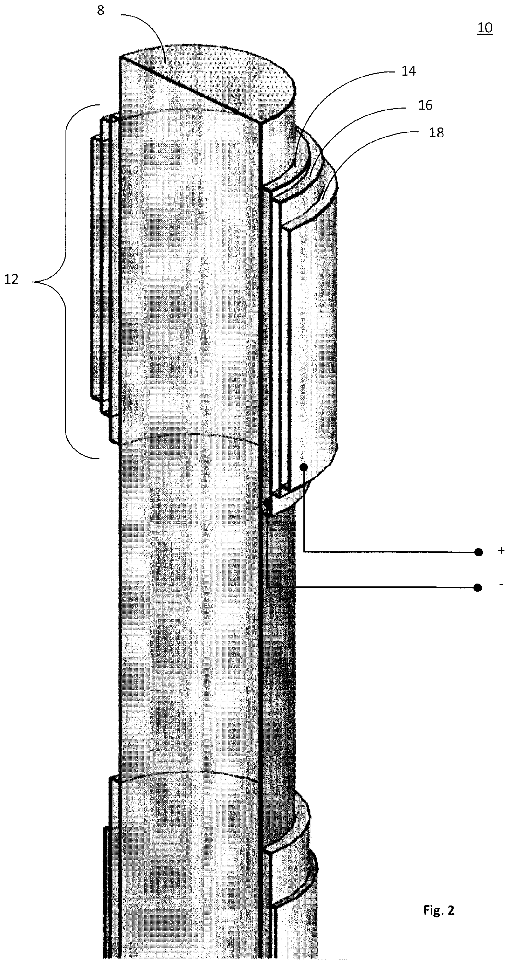

As illustrated on Fig. 2, in a preferred embodiment, the fiber 10 comprises a photovoltaic fiber section 12 configured to convert the radiation emitted by the tubular radiation emitter 1 into electricity, the photovoltaic fiber section 12 being provided in a section of the fiber 10 other than said catalytic section 2. According to the embodiment shown on Fig. 2, photovoltaic fiber section 12 is provided in a concentrically arranged layered structure around the outer circumference of the fiber 10 as follows:
- as a first "layer", the core 8 is longitudinally surrounded (around its outer circumference) by a radiation transmissive first tubular electrode 14;
- the first tubular electrode 14 is then longitudinally surrounded (around its outer circumference) by a photosensitive layer 16; and
- the photosensitive layer 16 is longitudinally surrounded (around its outer circumference) by a second tubular electrode 18.

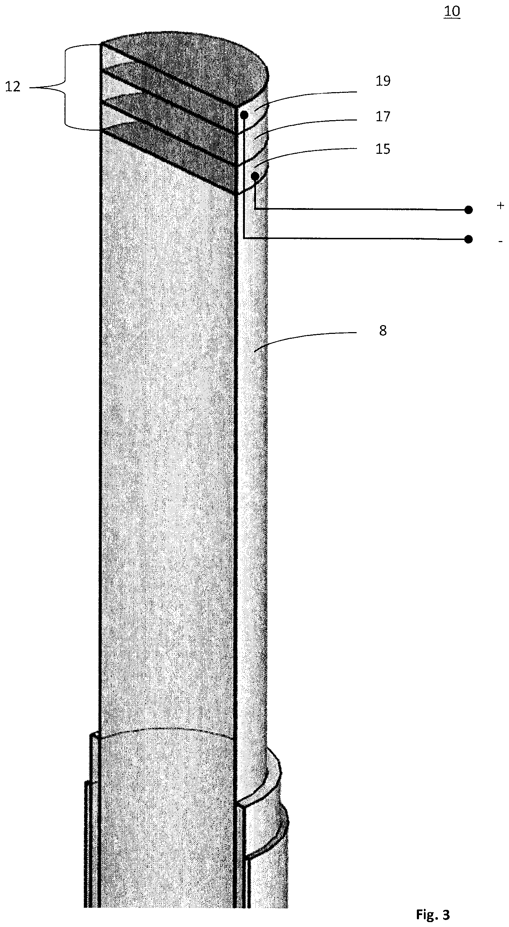

Figure 3 shows a perspective cross section of the photovoltaic fiber section 12 of a further embodiment of the energy conversion and transfer fiber 10, arranged at an extreme end of the core 8 (much like as an extension thereof) as follows:
- a radiation transmissive first disc-like electrode 15 is arranged axially adjacent to the core 8;
- a photosensitive disc 17 is arranged axially adjacent to the first disc-like electrode 15 and
- a second disc-like electrode 19 is arranged axially adjacent to the photosensitive disc 17

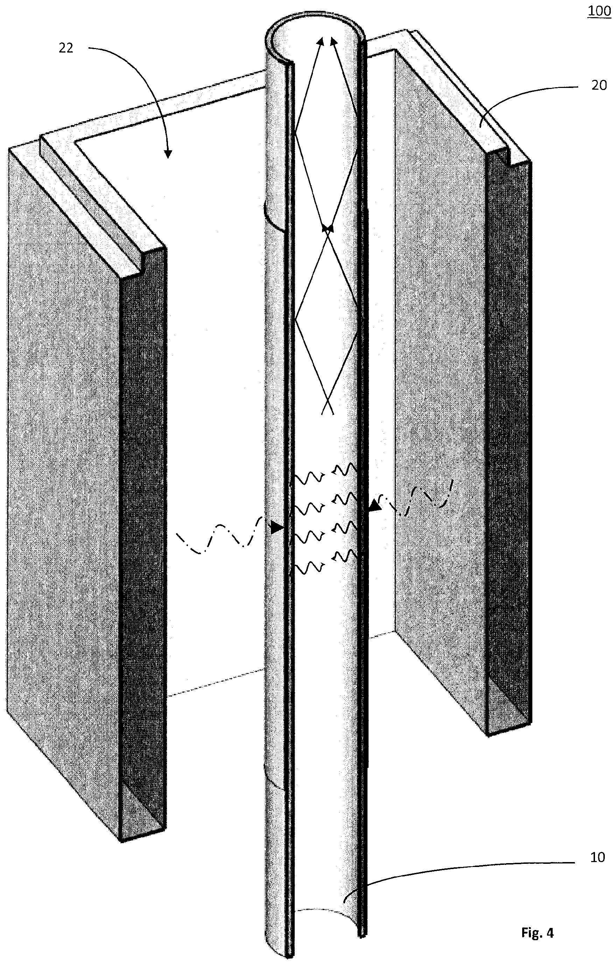

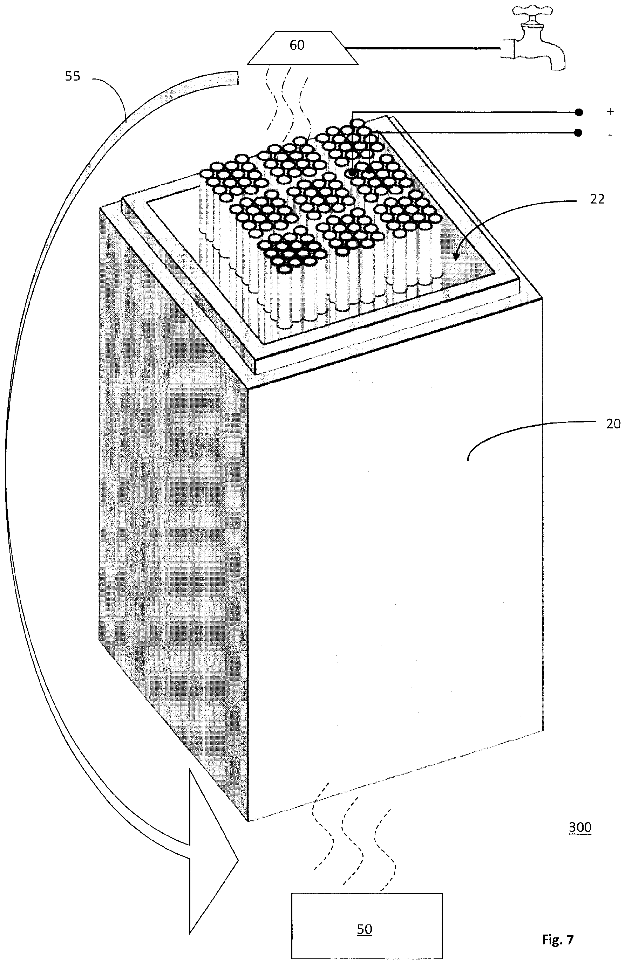

Turning now to Fig. 4, a combustion, heat-exchange and emitter device 100 for converting chemical energy into electro-magnetic radiation according to the present invention, having an energy conversion and transfer fiber 10 within a chamber enclosure 20 shall be described. As shown on this figure, in order to confine the chemical energy released by a fuel, a chamber enclosure 20 is provided, which preferably has a low heat conductivity for achieving increased thermal isolation and thus an increased efficiency. Preferably the chamber enclosure 20 is made of a high temperature resistant material such as a ceramic material, the chamber enclosure 20 defining a flow-through heat transfer chamber 22. The at least one energy conversion and transfer fiber 10 is arranged with its/their corresponding catalytic section(s) 2 within this flow-through heat transfer chamber 22. As it shall be described in detail with reference to figure 7, a fuel source 50 is arranged such as to direct a combustible fuel mixture from the fuel source 50 (Fig. 7) towards an input side of the flow-through heat transfer chamber 22. The flow-through heat transfer chamber 22 is configured such that the combustion is essentially limited to the surface of the tubular radiation emitter 1, in particular to it's a catalytic section 2. As indicated by "bouncing" arrows with continuous lines, the near-infrared radiation emitted by the selective emitter material is transferred along the length of the fiber 10 within its core 8, by means of internal reflection at the interface between the core 8 and tubular radiation emitter 1 due to a lower index of refraction of the latter.

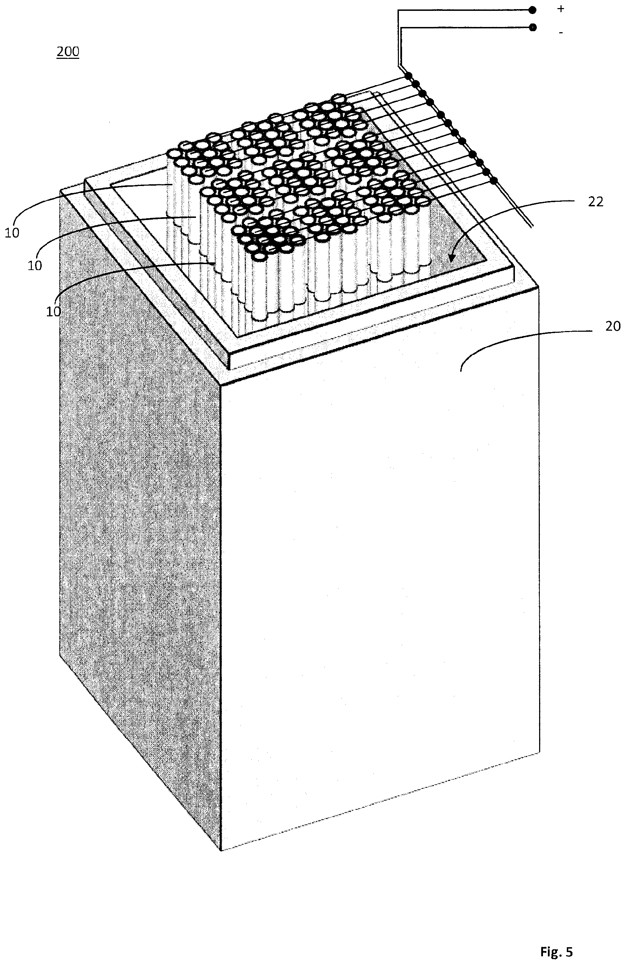

Fig. 5 shows a perspective view of a combustion, heat-exchange and emitter device 100 (Fig. 4) for converting chemical energy into electro-magnetic radiation according to the present invention, having multiple bundles of energy conversion and transfer fibers 10 within a chamber enclosure 20, each fiber 10 comprising a photovoltaic fiber section 12, electrical connections thereto being illustratively shown too. The bundles of energy conversion and transfer fibers 10 are arranged with their corresponding catalytic section(s) 2 within said flow-through heat transfer chamber 22 such as to optimize catalytic combustion on said catalytic section(s) 2 of a fuel provided within the flow-through heat transfer chamber 22.

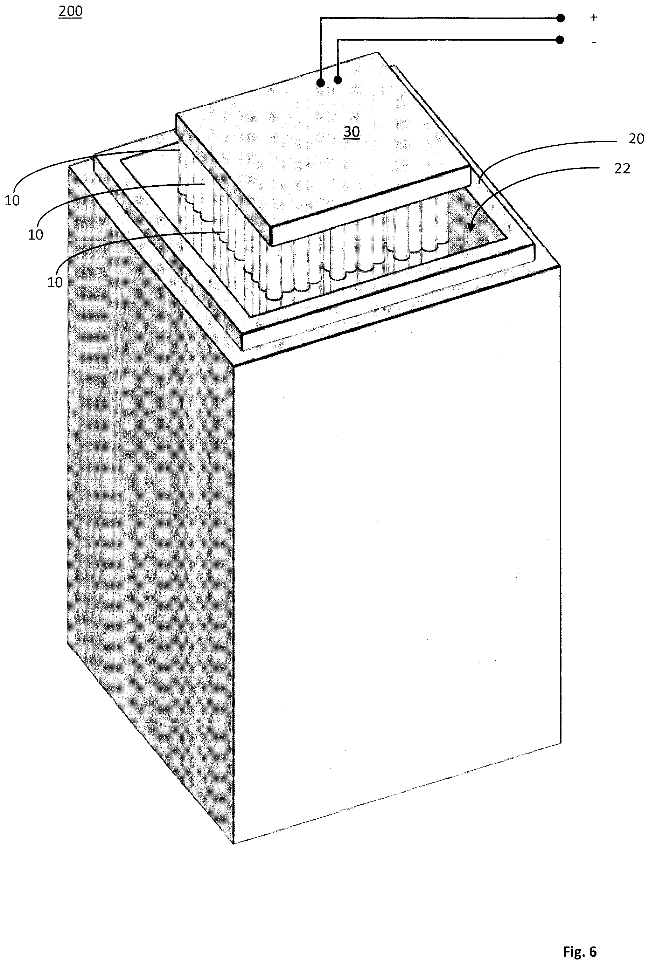

An alternative to each fiber 10 comprising a photovoltaic fiber section 12, a single photovoltaic cell 30 may be butt-coupled with extreme ends of all the fibers 10 as shown on figure 6. As a further alternative (not shown) separate photovoltaic cells 30 may be coupled each bundle of fibers 10.

Fig. 7 schematically illustrates a perspective view of a thermophotovoltaic system 200 according to the present invention, comprising a thermophotovoltaic device 100 and a fuel source 50 and configured to act as a heat/ electric energy/ light/ clean water source. An inflow of combustible fuel mixture at an input side of the flow-through heat transfer chamber 22 is shown on the figures with wave-shaped dashed lines, while the out-flow of exhaust gases at an exhaust side of the flow-through heat transfer chamber 22 is shown with dotted-dashed wave-shaped lines.

The fuel source 50 is a chemical energy source, wherein the chemical energy carrier is a fossil or synthetic fuel such as Methanol.

As shown on figure 7, the thermophotovoltaic system 200 further comprises a waste heat recovery unit 55 configured to recover heat from exhaust gases at the exhaust side of the flow-through heat transfer chamber 22 and feedback said recovered heat to said input side. In another example, the recovered heat or energy is used for other purposes.

A further advantageous embodiment of the thermophotovoltaic system 200 further comprises a condenser unit 60 configured to recover liquid by condensing vapour in the exhaust gases at said exhaust side of the flow-through heat transfer chamber 22. In case the fuel is Methanol for example, the condenser unit 60 is laid out for condensing water vapours resulting from combustion of the Methanol. In this way, the thermophotovoltaic system 200 is also capable of acting (simultaneously or selectively) as a source of pure water and at the same time allowing for compensative heat recovery.

It will be understood that many variations could be adopted based on the specific structure hereinbefore described without departing from the scope of the invention as defined in the following claims. For example, the heat or energy can be recovered to the input side of the thermophotovoltaic system 300 and/or to external applications, which in particular are based on high or low temperature technology.

In another example, heat of condensation is alternatively or additionally recovered. This way, an additional increase of approximately 10% efficiency can be achieved.

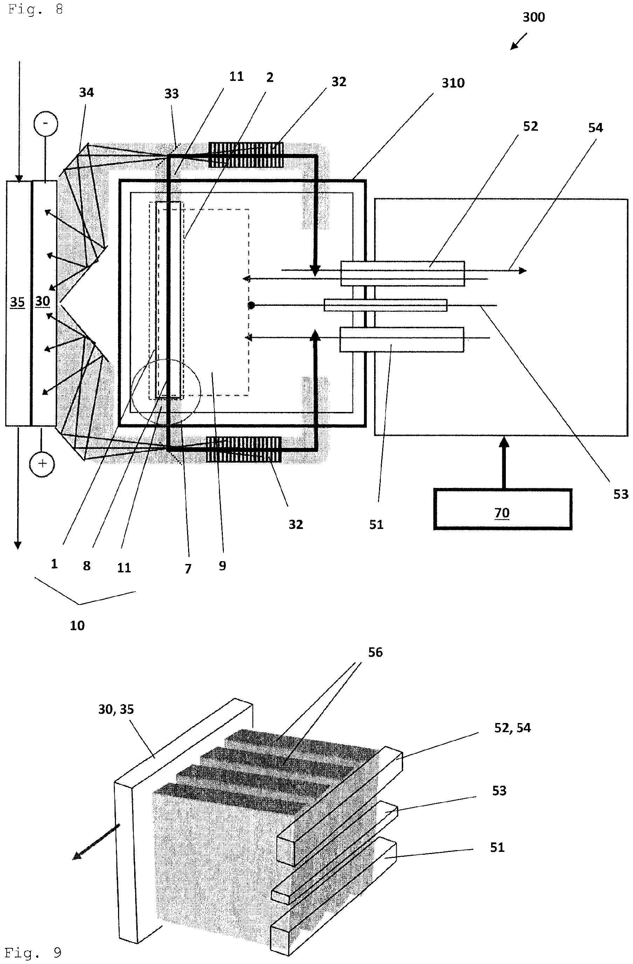

Fig. 8 shows a schematic view of a thermophotovoltaic system 300 according to the present invention with a combustion chamber 310 and an energy conversion and transfer media 10 according to the present invention.

The combustion chamber 310 comprises a first inlet 51 for supplying a fuel gas and a second inlet 52 for supplying oxygen to the combustion chamber 310, further an igniter 53 for providing an ignition within the combustion chamber 310 and an exhaust 54 for exhausting the waste gas out of the combustion chamber 310. The inlets 51, 52 and the exhaust 54 comprise a valve, which is connected to a control unit 70 for individually controlling the flow of gas through the inlets 51, 52 and the exhaust 54 respectively. Further, the igniter 53 is electrically or optically connected to the control unit 70, which is configured to control the ignition in the combustion chamber 310.

The energy conversion and transfer media 10 comprises a tubular radiation emitter 1, an Yb-doped core 8 and a glass rod 11. The glass rod 11 comprises two remote ends, which are located within the combustion chamber 310, and two intermediate parts, which are located exterior to the combustion chamber 310. These two intermediate parts interconnect the two remote ends of the glass rod 11 with the Yb-doped core 8. The remote end feed the emitted light back into the combustion chamber 310 for recovery of remaining radiation. This radiation leaves these two remote ends of the glass rod 11 and provides the additional energy in the combustion chamber 310.

Two bragg filter, in this case implemented by two bragg gratings 32, are interconnecting the intermediate part of the glass rod 11 for selectively decoupling radiation that passes through these intermediate parts. In addition, an optically transparent device is attached to the energy conversion and transfer energy conversion and transfer media 10 for transferring the decoupled radiation of the bragg gatings 32 to a photovoltaic element 30 in order to provide even spreading of the light intensity over the entire area of the photovoltaic cell. Each of the bragg gatings 32 emits the decoupled radiation trough a partially transparent mirror 33, two intermediate mirrors 34 to a photovoltaic element 30. Further, a cooling element 35 is attached to the photovoltaic element 30.

In operation, a flow of CH₃OH gas is injected via the first inlet 51 and a flow of O₂ gas is injected via the second inlet 52. These two gases mix in the combustion chamber 310 and combust after self-ignition due to sufficiently high temperatures or after being ignited by the igniter 53. The combustion generates heat energy with temperatures in the range of approximately 800°C to 1700°C. The heat energy is converted into light energy as described above, for example in connection with Fig. 1.

In one example, the flow of CH₃OH gas injected via the first inlet 51 and/or a flow of O₂ gas injected via the second inlet 52 are injected in an intermittent or pulse-shaped manner. This way a precise control of the combustion process is possible, for example a control according to the actual power demand. On a further example, the intermittent flow of fuel and/or O₂ gas is controlled within a tolerance of milliseconds.

The combustion produces exhaust gas, which is exhausted via the exhaust 54. As described in connection with Fig. 7, the energy of the exhaust gas can be recovered by a waste heat recovery unit 55 (Fig. 7) and/or the liquid by a condenser unit 60 (Fig. 7).

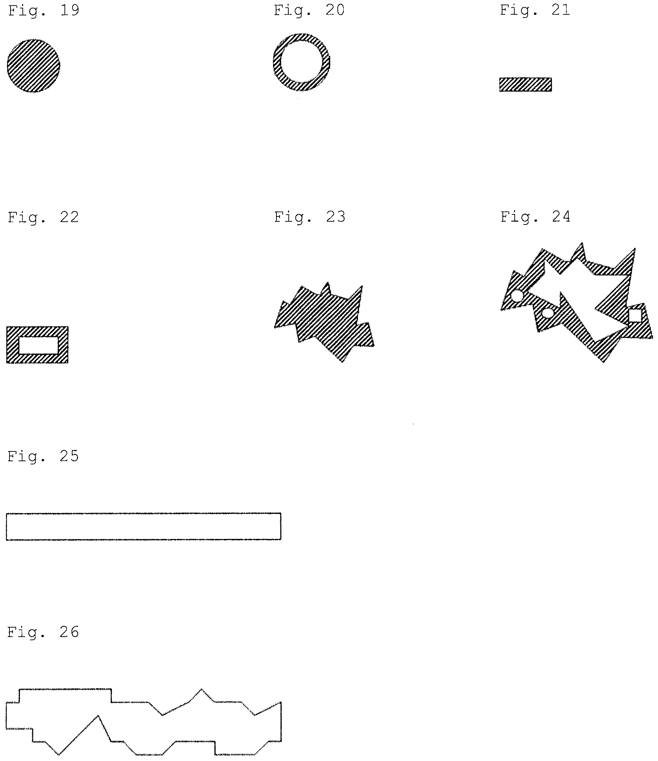

In Fig. 1 to 18, the core of the energy conversion and transfer media has a cylindrical-symmetrical cross section shape. However, the core 8 can have other shapes, for example the core can be formed as a plate 9, i.e. cuboid with rectangular cross section as shown in Fig. 21 or 22 (indicated in Fig. 8 by the dashed line).

A detail view 7 of the interconnection between the core 8 and the undoped glass rod 11 or fiber is indicated in Fig. 8 by the dotted-dashed line. Detail views of different configurations and further embodiments are depicted in Fig. 12 to 17.

The core 8 can be formed according a variety of shapes. Examples of such variations of the shape in the radial direction are shown in Fig. 19 to 24 and examples of variations of the shape in the axial direction are shown in Fig. 25 and 26. Further, the variations of the shape in the radial direction can be combined with the variations of the shape in the axial direction.

In the propagation of the useful radiation as little as possible of the useful radiation is reabsorbed or exits unused to side to the glass rod 11 (light guide A). The glass rod 11 is not doped with Yb.

The combustion process (for example using methanol and oxygen) is preferably localized to the surface of the glass rod 11 and does not take place in the volume. Therefore the heating of the fiber is maximized. In particular, this allows to use effects of candoluminescence and thermal non-equilibrium states associated thereto. These effects are e.g. caused by the involvement of free radicals and are used to locally and for a short time raise the temperature significantly above the equilibrium temperature or to efficiently transfer the energy content of excited free radicals, for example in the form of a dipole-dipole interaction, as an excitation energy to the 4f electron in the Yb atom.

Besides the embodiment of a fiber 8 with cover as shown in the Fig. 8, the core 8 can take other forms, for example a hollow fiber or a plate.

The doping of the optical fiber 8 can be homogeneous or in such a way that the fiber supports the generation of the usable light, for example by use of phase correlation (the concentration of dopant varies periodically, for example, with the period that corresponds to an integral or half-integral multiple of the wavelength of the useful light) or within the optical fiber 8, possibly differently in axially as well as radial direction, in order to optimize various parameters such as the place of generation, the intensity, the wavelength or the phase of usable light. A catalytic section 2, also called catalytically active layer, which is indicated in Fig. 8 as a dotted line, concentrates the combustion process on the surface of the optical fiber 8. This catalytic section 2 is homogeneous and sharply defined and evenly covers the light-generating optical fiber 8 to the beginning of the non-light-generating glass rod 11. However, the catalytic section 2 can also be structured differently, for example, phase-out towards the non-light-generating glass rod 11, covering the light-generating optical fiber non-homogeneous or with varying layer thickness or porous, as well as appropriate combinations thereof.

Fig. 9 shows a perspective view of a modular system 400 with 4 modules 56, wherein each of the modules 56 comprises a thermophotovoltaic system according to Fig. 8.

The modules 56 are identical and each module has the dimension of approx. 1 cm x 1 cm x 0.2 cm. The modules 56 are arranged in parallel and spaced apart to each other. On one of the side walls of the modules 56, the modules 56 abut a photovoltaic cell 30. The photovoltaic cell 30 also comprises a cooling element 35 (not shown). On the side walls opposite to the photovoltaic element 30, the modules are interconnected by a first inlet 51 with an exhaust 54, a second inlet 52 and an igniter 53. The first inlet 51 provides fuel to each of the modules, in this example Methanol. A second inlet 52 and the exhaust 54 are arranged parallel to the first inlet 51 provide air or oxygen to each of the modules and provide an outlet for the combustion gases. The igniter 53 is arranged between the first inlet 51 and the second inlet 52. Thus, the first inlet 51, the second inlet 52, the exhaust 54 and the igniter 53 interconnect the same side walls of the modules 56. In this example, the common photovoltaic cell 30 produces an electrical power of approximately 1 Watt.

The modules 56 can further be combined to provide a system with a large number of substantially identical modules. For example, these modules are combined on an area of 10 cm x 10 cm to produce an electrical power of approximately 100 Watt. Such a system is particularly scalable and advantageously provides easy adoption of the system to a large range of power requirements and/or specific needs of different applications. Further, due to the assembly of numerous identical parts, such a modular system is particularly suitable for mass production.

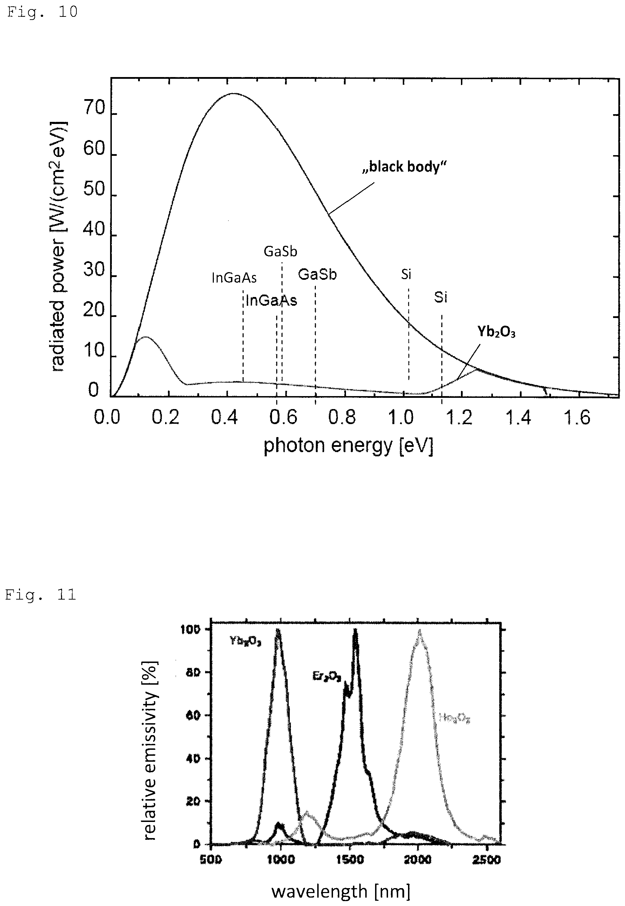

Fig. 10 shows a diagram depicting a spectrum of near-infrared radiation. The x-axis indicates the photon energy eV of the near-infrared radiation und the y-axis the radiated power W/(cm²ev).

The diagram shows a numerical calculation of the radiated power spectrum of an Yb₂O₃ emitter (lower curve), which corresponds to the heated Yb-doped radiation emitter 1 of Fig. 8. The Yb₂O₃ emitter radiates predominantly near-infrared radiation with an intensity peak at a wavelength of approximately 1 µm. As shown in connection with Fig. 8, the near-infrared radiation with wavelength λ of approximately 1 µm can be decoupled by use of a bragg grating 32 (Fig. 8).

For comparison, the diagram shows the related "black body" radiation spectrum (upper curve) at a temperature of T=1735 °K. Also indicated are the band gap energies of the different semiconductor materials as shown in Fig. 11.

A "blackbody" emits electromagnetic radiation according to Planck's radiation law and a temperature up to about 1500-2000 ° C is reachable with technically simple means. However, the major part of this radiation is not directly usable for the production of electrical energy by means of photovoltaic cells. By using non-black materials or selectively emitting materials such as Yb₂O₃, a significantly greater proportion, ideally the entire selectively radiated power, is useable for electricity production.

Further, from location of production of the emitted electromagnetic radiation to the location of transformation of this radiation into electrical energy, the electromagnetic radiation is kept within materials with refraction indices that are never less than a minimal value, i.e. nₘᵢₙ. This way the emitted power density is amplified by a factor of nₘᵢₙ² in comparison to an exit of the electromagnetic radiation into air or vacuum.

Fig. 11 shows a diagram illustrating the relative emissivity of a selective emitter in dependence of wavelength. The x-axis indicates the wave length in nm and the y-axis the relative emissivity in %. The diagram shows the dependency for three rare earth materials, which are used as selective emitting materials, namely Ytterbiumoxide (Yb2O3), Erbiumoxide (Er2O3) and Holmiumoxide (Ho2O3). These materials are ideal for generating electric energy, if photovoltaic cells with corresponding semiconductor materials are used.

The following table shows a suitable matching of the selective emitting with the material of the photovoltaic cell for an optimized production of electrical energy:

| **Emitter material** | **Suitable photovoltaic cell** | **Band gap [nm]** | **Band gap [eV]** |
|---|---|---|---|
| Ytterbiumoxide (Yb₂O₃) | Silicon (Si, mono crystalline) | 1100 | 1.13 |
| Erbiumoxide (Er₂O₃) | Gallium-Antimonite (GaSb) | 1770 | 0.70 |
| Holmiumoxide (Ho₂O₃) | Indium-Gallium-Arsenide (InGaAs) | 2200 | 0.57 |

Fig. 12 shows a schematically simplified detail view 7 of the energy conversion and transfer media according to Fig. 8 with a doped light guide C and an undoped light guide A.

The undoped light guide A corresponds to the glass rod 11 of Fig. 8 and provides transportation with minimal absorption and scattering of the usable light, but does not generate the light itself.

The doped light guide C corresponds to the core 8 of Fig. 8 and generates usable light in the interior of the light guide.

Fig. 13 shows a detail view of the energy conversion and transfer media according to Fig. 12, wherein the light guide is additionally coated with a catalytic coating B.

The catalytic coating B, an active coating, provides the generation of high temperatures, also in the state of non-equilibrium. This allows to use the effect of candoluminescence. Further, the combustion process is localised on the surface of the light guide C and a propagation and/or initiation of the combustion process within the volume is effectively suppressed.

Fig. 14 shows a detail view of the energy conversion and transfer media according to Fig. 12, wherein the doped light guide C is a hollow body. An example of a cross section of such a hollow body is shown in Fig. 20.

Fig. 15 shows a detail view of the energy conversion and transfer media according to Fig. 14, wherein additionally the undoped light guide A is a hollow body.

Fig. 16 shows a detail view of the energy conversion and transfer media according to Fig. 14, wherein the light guide C is additionally coated with the catalytic coating B as mentioned above.

Fig. 17 shows a detail view of the energy conversion and transfer media according to Fig. 15, wherein the light guide C is additionally coated with the catalytic coating B.

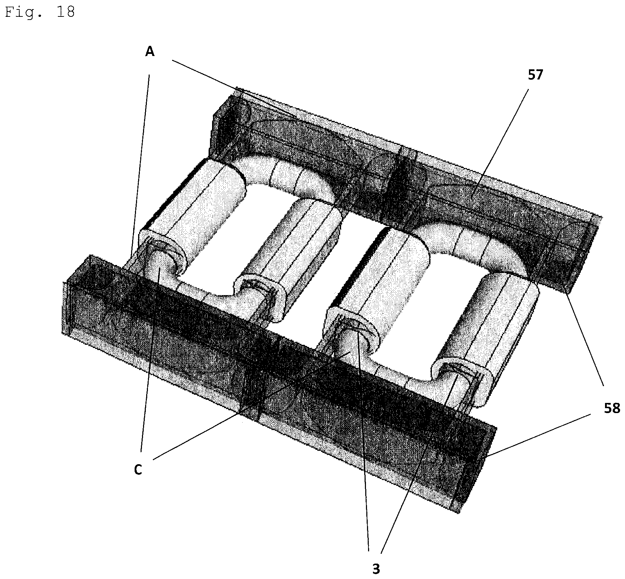

Fig. 18 shows a schematic view of a thermophotovoltaic system according to the present invention with two basic elements arranged side by side to each other to form a module. Each of the basic elements corresponds to a thermophotovoltaic system 300 as shown in Fig. 8.

The module comprises an undoped light guide A, a doped light guide C, a catalytic section 2, a spectral shaper 3, a space 57 for thermal insulation and gas tight elements 58. For example, the space 57 for thermal insulation is a vacuum and/or the gas tight elements 80 form a chamber enclosure. In another example, the spectral shaper 3 is arranged between the undoped light guide A and a radiation emitter.

On the resulting two front sides, the PV cell (30, Fig. 8) with cooling (35, Fig. 8) can be contacted directly. The feeding with fuel (51-54, Fig. 8) and its controlling by a controller (70, Fig. 8) can then be performed with a module specific device.

This modular design allows for "endless" modular repetition in all directions.

Fig. 19 to 26 show different embodiments of the core 8 of the energy conversion and transfer media 10 of Fig. 8. The core 8 is shaped differently, in axial direction as shown in the examples of Fig. 19 to 24 and in the radial direction as shown in examples of Fig. 25 or 26.

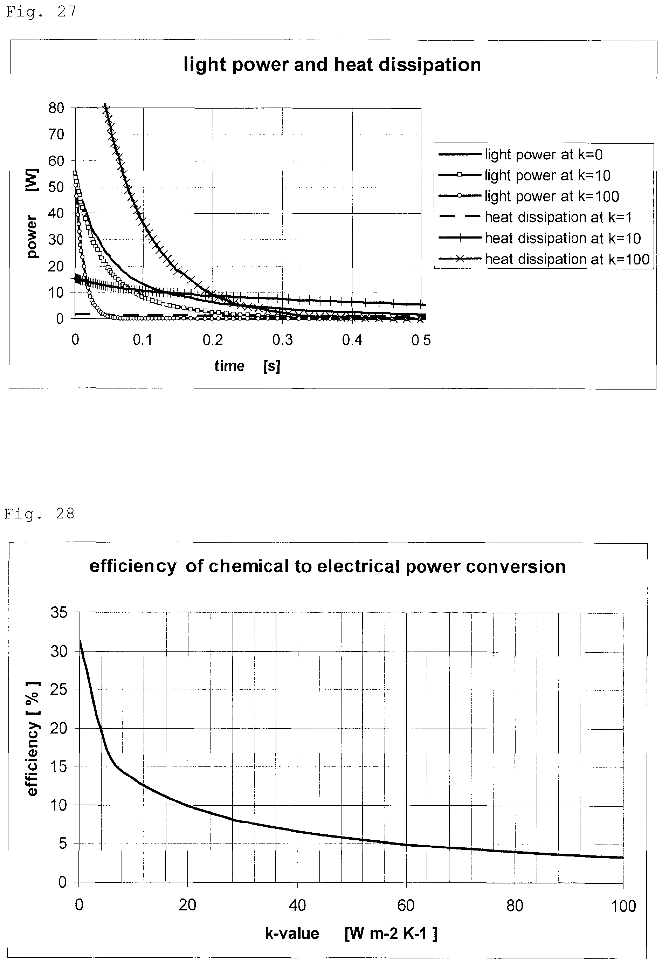

Fig. 27 shows a diagram showing the time dependency of light power and heat dissipation. The vertical axis represents the power in W and the horizontal axis represents the time in seconds.

The diagram depicts the results of numerical modeling of the entire outgoing light power at the end of an optical fiber and a heat losses of a combustion chamber, i.e. a heat transfer chamber, as a function of time and a heat dissipation k of the heat transfer chamber (combustion chamber). The heat dissipation k was selected to be 1, 10 and 100.

Fig. 28 shows a diagram showing the dependency of efficiency from the heat dissipation k of the heat transfer chamber. The vertical axis represents the efficiency in % and the horizontal axis represents the heat dissipation k in W/m2/K.

The diagram depicts the results of numerical modeling of the efficiency in function of a k-value, which represents the heat dissipation k of the heat transfer chamber resp. the combustion chamber.

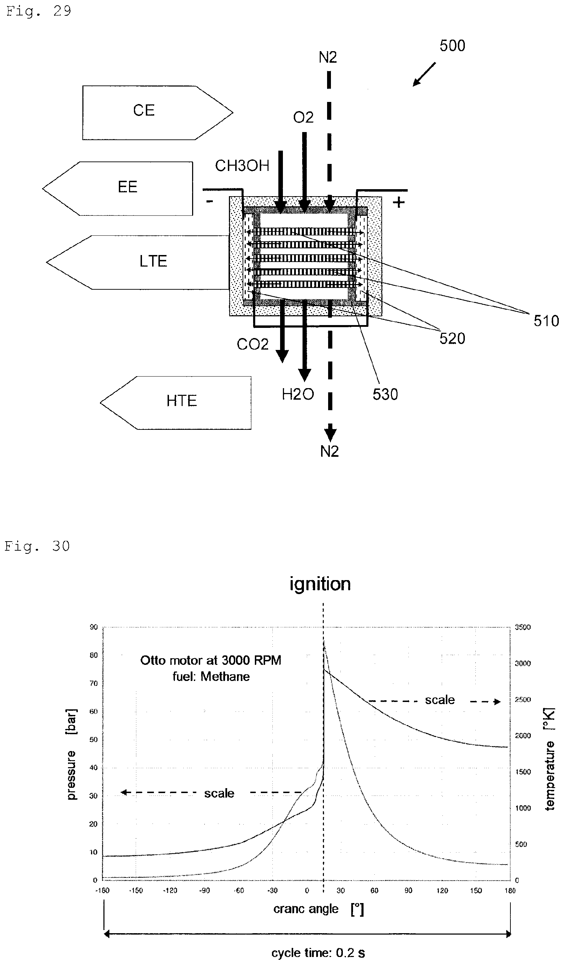

Fig. 29 shows a schematically simplified block diagram of the thermophotovoltaic system 500 according to the invention, which comprises - among others - a Yb doped fiber 510, a PV cell 520 and a thermal insulation 530.

The figure depicts a schematic representation of the thermophotovoltaic system 500 resp. an arrangement for generating electric power by a pulsed combustion of Mathanol.

The thermophotovoltaic system 500 is fed by input energy in form of chemical energy CE and provides output energy in form of an electrical energy EE, a low temperature energy LTE and a high temperature energy HTE.

In this example, the thermophotovoltaic system 500 is controlled by the following parameters: the number of the Yb doped fibers 510, the amount of CH3OH, O2 and N2, the heat dissipation of the heat transfer chamber (i.e. the combustion chamber), the refraction index of the Yb doped fiber 510 and/or refraction index of the PV cell 520 and the efficiency of the PV cell 520.

Fig. 30 shows a diagram illustrating the pressure and temperature profile of an Otto motor at a velocity of 3000 rotations per minute (RPM). The left vertical axis represents the pressure in bar, the right vertical axis represents the temperature T in K and the horizontal axis represents the crank angle. The ignition at approx. 10° crank angle is indicated by a vertical dotted line. A variation of the crank angle from -180° to +180° corresponds to 0.2 seconds.

The curve progression of the diagram depicts the course of pressure and temperature at an Otto motor after ignition of a methane/air mixture. (source: http://enthalpos.blogspot.ch/2011/01/verbrennunqsmotor-mit-propan.html) .

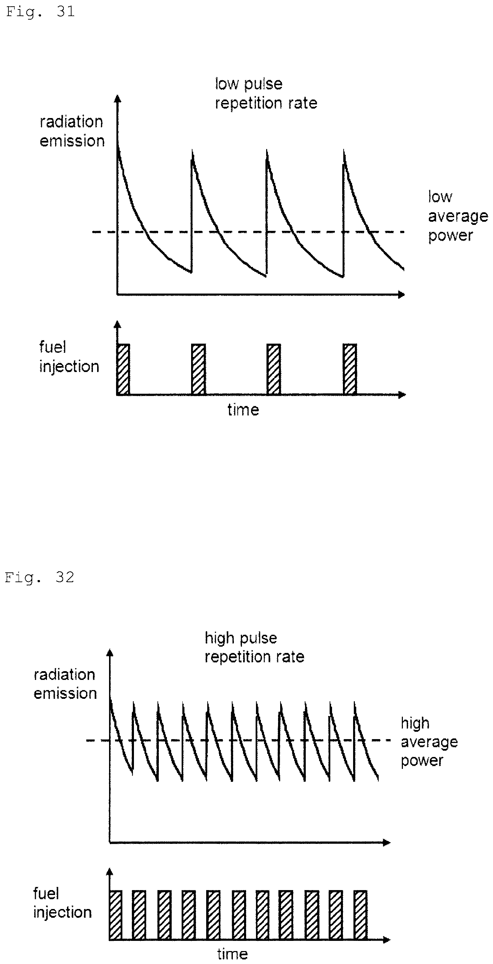

Fig. 31 shows a diagram that depicts the time dependency of the radiation emission and the fuel injection of a thermophotovoltaic system according to the invention when performing the combustion process as a pulsed combustion, i. e. when operated with pulsed combustion.

The vertical axis of the upper part of the diagram represents the radiation emission, the vertical axis of the lower part of the diagram represents the fuel injection and the horizontal axis of each part represents the time. In this example, the pulsed combustion is implemented by injecting a series of intermitted, in particular periodic, fuel pulses, each performing a rectangular shaped fuel injection. Other implementations are also possible, for example a pulsed air resp. oxygen injection or a combination of pulsed fuel and pulsed air resp. oxygen injection.

During the fuel injection and corresponding to the beginning of the fuel injection pulse, the radiation emission increases with a steep slope after each fuel injection and - after having reached a maximum - decays at a significantly slower rate, in particular in a substantially exponentially manner. The resulting average power of the pulsed combustion is schematically indicated by a dashed line.

In this example, the thermophotovoltaic system is operated at a low pulse repetition rate and the resulting average power is low.

Fig. 32 shows the diagram according to Fig. 31, wherein however the thermophotovoltaic system is operated at a high pulse repetition rate, in particular at a higher pulse repetition rate than the pulse repetition rate of the previous example shown in Fig. 31. The average power (schematically indicated by a dashed line) is high, in particular higher than the average power that corresponds to the low pulse repetition rate as shown in Fig. 31.

**REFERENCE LIST:**

| | |
|---|---|
| undoped light guide | A |
| doped light guide | C |
| radiation emitter | B, 1 |
| plate-shaped radiation emitter | 1' |
| catalytic section (of tubular radiation emitter) | 2 |
| spectral shaper | 3 |
| transparent core | 8 |
| plate | 9 |
| energy conversion and transfer media | 10 |
| glass rod | 11 |
| photovoltaic fiber section (of tubular radiation emitter) | 12 |
| first tubular electrode | 14 |
| first disc-like electrode | 15 |
| photosensitive layer | 16 |
| photosensitive disc | 17 |
| second tubular electrode | 18 |
| second disc-like electrode | 19 |
| chamber enclosure | 20 |
| flow-through heat transfer chamber | 22 |
| photovoltaic cell | 30 |
| bragg grating | 32 |
| partially transparent mirror | 33 |
| mirror | 34 |
| cooling | 35 |
| fuel source | 50 |
| first inlet | 51 |
| second inlet | 52 |
| igniter | 53 |
| exhaust | 54 |
| waste heat recovery unit | 55 |
| modules | 56 |
| space for thermal insulation | 57 |
| gas tight elements | 58 |
| a condenser unit | 60 |
| control unit | 70 |
| combustion, heat-exchange and emitter device | 100 |
| thermophotovoltaic device | 200 |
| thermophotovoltaic system | 300 |
| combustion chamber | 310 |
| modular system | 400 |
| thermophotovoltaic system | 500 |
| Yb doped fiber | 510 |
| PV cell | 520 |
| thermal insulation | 530 |
| chemical energy | CE |
| electrical energy | EE |
| low temperature energy | LTE |
| high temperature energy HTE | |

## Claims

1. A thermophotovoltaic system (300) comprising:
- a heat transfer chamber (22), and
- at least one energy conversion and transfer media (10), which comprises:
- a transparent core (8) for energy transfer and
- a selective emitter material configured for emitting predominantly near-infrared radiation when heated up to high temperatures, wherein the transparent core (8) is doped with said selective emitter material and/or the energy conversion and transfer media (10) comprises a, in particular tubular, radiation emitter (1) doped with said selective emitter material, wherein the transparent core (8) is arranged within said radiation emitter (1) and/or between at least two separate parts of said radiation emitter (1),
the at least one energy conversion and transfer media (10) being arranged within said heat transfer chamber (22) and being coupled, preferably butt-coupled, to at least one photovoltaic cell (30) and/or comprising at least one photovoltaic section (12) that is configured to convert the radiation emitted by the radiation emitter (1) into electricity,
the thermophotovoltaic system (300) further comprising a fuel source (50) for performing a combustion process in said heat transfer chamber (22),
**characterized in that**
the thermophotovoltaic system (300) is configured to perform the combustion process as a pulsed combustion.

2. The thermophotovoltaic system (300) according to claim 1, wherein a catalytic section (2) of an outer surface of said energy conversion and transfer media (10), in particular of said radiation emitter (1), is arranged within said heat transfer chamber (22) and/or is at least partially provided with a catalytic coating in order to maximize heat transfer between a chemical energy carrier and said catalytic section (2) and/or to provide surface reactions, which in particular cause candoluminescence.

3. The thermophotovoltaic system (300) according to claim 1 or 2, said energy conversion and transfer media (10) is configured as an optical fiber and/or an optical rod such as a glass rod, wherein in particular the radiation emitter (1) has an index of refraction lower than the transparent core (8), so as to provide for an internal reflection, preferably total internal reflection, of radiation within the transparent core (8) so as to thereby confine said radiation therein.

4. The thermophotovoltaic system (300) according to any one of the preceding claims, wherein a spectral shaper (3) is provided between the radiation emitter (1) and the transparent core (8), wherein said spectral shaper (3) is configured as:
- a band pass filter for a first, optimal spectral band of the radiation emitted by the radiation emitter (1) when exposed to high temperature; and/ or
- a reflector for further, non-optimal spectral band(s) of the radiation emitted by the radiation emitter (1), so that said second, non-optimal spectral band radiation is recycled as radiation redirected towards the radiation emitter (1).

5. The thermophotovoltaic system (300) according to any one of the preceding claims, wherein the transparent core (8) is made of a material such as SiO2, YAG (Yttrium Aluminum Garnet) or Yb and/or the transparent core (8) and/or the radiation emitter (1) is doped with a rare earth containing material, preferably with Ytterbium containing material, further in particular with Ytterbium-oxide Yb2O3.

6. The thermophotovoltaic system (300) according to any one of the preceding claims, wherein said at least one photovoltaic section (12) is a fiber section and/or is provided in a section of the energy conversion and transfer media (10) other than a catalytic section (2).

7. A thermophotovoltaic system (300) according to any one of the preceding claims, comprising a thermophotovoltaic device (200) for converting chemical energy into electricity, the thermophotovoltaic device (200) having a combustion, heat-exchange and emitter device (100) for converting chemical energy into electro-magnetic radiation, the combustion, heat-exchange and emitter device (100), which comprises a chamber enclosure (20) and the at least one energy conversion and transfer media (10) and/or said at least one photovoltaic cell (30) or photovoltaic section (12).

8. The thermophotovoltaic system (300) according to any one of the preceding claims, comprising at least one photovoltaic section (12), wherein along said photovoltaic section(s) (12):
- the transparent core (8) is longitudinally surrounded by a radiation transmissive first, in particular tubular, electrode (14);
- the first electrode (14) is covered, in particular longitudinally surrounded, by a photosensitive layer (16); and
- the photosensitive layer (16) is covered, in particular longitudinally surrounded, by a second, in particular tubular, electrode (18).

9. The thermophotovoltaic system (300) according to any one of the preceding claims, comprising at least one photovoltaic section (12), wherein within said photovoltaic section(s) (12):
- a radiation transmissive first, in particular disc-like, electrode (15) is arranged, in particular axially, adjacent to the transparent core (8);
- a photosensitive element (17), in particular a photosensitive disk, is arranged, in particular axially, adjacent to the first electrode (15); and
- a second, in particular disc-like, electrode (19) is arranged, in particular axially, adjacent to the photosensitive element (17).

10. The thermophotovoltaic system (300) according to any one of the preceding claims, wherein the transparent core (8) is operationally connected to a bragg filter (32), in particular a bragg gating and/or bragg fibre filter, for a selectively decoupling of said emitted predominantly near-infrared radiation, in particular a radiation with a wavelength (λ) in a range from 0.5 µm to 1.5 µm, in particular of approximately 1 µm.

11. The thermophotovoltaic system (300) according to any one of the preceding claims, configured to perform an isochoric and/or adiabatic combustion and/or configured to feed oxygen, in particular heated oxygen, into the heat transfer chamber (22) in an intermittent and/or pulse-shaped manner.

12. The thermophotovoltaic system (300) according to any one of the preceding claims, comprising a fuel source (50) arranged such as to direct a combustible fuel mixture from the fuel source (50) towards said heat transfer chamber (22), wherein in particular said fuel source (50) is a chemical energy source, wherein the chemical energy carrier is a fossil or synthetic fuel such as Methanol and/or said fuel source (50) is configured to feed the fuel in an intermittent and/or pulse-shaped.

13. The thermophotovoltaic system (300) according to any one of the preceding claims, configured as a portable energy source such as to simultaneously or selectively:
- act as a heat source providing heat radiation from the thermal energy source (50) and/or the heat transfer chamber (22) and/or;
- act as a source of electric energy providing electric energy;
- act as a light source at a distal end(s) of said at least one of energy conversion and transfer media (10), the radiation emitter (1) being configured such as to provide electro-magnetic radiation also in the visible spectrum when exposed to high temperature.

14. A modular system (400) comprising a plurality of modules (56), each comprising the thermophotovoltaic system (300) according to any one of the preceding claims, wherein in particular the modules (56) are interconnected via at least one of:
- a photovoltaic cell (30),
- a first inlet (51),
- a second inlet (52),
- an igniter (53), and
- an exhaust (54).

15. The modular system (400) according to the preceding claim, wherein the pulsed combustion in each thermophotovoltaic system (300) is individually controlled, in particular by a pulsed adding of oxygen to a previously fed fuel.

## Patentansprüche

1. Thermophotovoltaiksystem (300), umfassend:
- eine Wärmeübertragungskammer (22) und
- mindestens ein Energieumwandlungs- und -übertragungsmedium (10), das umfasst:
- einen transparenten Kern (8) zur Energieübertragung und
- ein selektives Emittermaterial, das zum Emittieren von Strahlung vorherrschend im nahen Infrarotbereich ausgelegt ist, wenn es auf hohe Temperaturen erwärmt wird, wobei der transparente Kern (8) mit dem selektiven Emittermaterial dotiert ist und/oder das Energieumwandlungs- und -übertragungsmedium (10) einen, insbesondere röhrenförmigen, Strahlungsemitter (1) umfasst, der mit dem selektiven Emittermaterial dotiert ist, wobei der transparente Kern (8) innerhalb des Strahlungsemitters (1) und/oder zwischen mindestens zwei Teilen des Strahlungsemitters (1) angeordnet ist,
wobei das mindestens eine Energieumwandlungs- und -übertragungsmedium (10) innerhalb der Wärmeübertragungskammer (22) angeordnet ist und mit mindestens einer Photovoltaikzelle (30) gekoppelt, bevorzugt auf Stoß gekoppelt, ist und/oder mindestens einen Photovoltaikabschnitt (12) umfasst, der dazu ausgelegt ist, die durch den Strahlungsemitter (1) emittierte Strahlung in Elektrizität umzuwandeln,
wobei das Thermophotovoltaiksystem (300) ferner eine Kraftstoffquelle (50) zum Durchführen eines Verbrennungsvorgangs in der Wärmeübertragungskammer (22) umfasst,
**dadurch gekennzeichnet, dass** das Thermophotovoltaiksystem (300) dazu ausgelegt ist, den Verbrennungsvorgang als gepulste Verbrennung durchzuführen.

2. Thermophotovoltaiksystem (300) nach Anspruch 1, wobei ein katalytischer Abschnitt (2) einer Außenfläche des Energieumwandlungs- und -übertragungsmediums (10), insbesondere des Strahlungsemitters (1), innerhalb der Wärmeübertragungskammer (22) angeordnet ist und/oder zumindest teilweise mit einer katalytischen Beschichtung versehen ist, um die Wärmeübertragung zwischen einem chemischen Energieträger und dem katalytischen Abschnitt (2) zu maximieren und/oder Oberflächenreaktionen bereitzustellen, die insbesondere Candolumineszenz bewirken.

3. Thermophotovoltaiksystem (300) nach Anspruch 1 oder 2, wobei das Energieumwandlungs-und -übertragungsmedium (10) als eine optische Faser und/oder ein optischer Stab wie etwa ein Glasstab ausgelegt ist, wobei insbesondere der Strahlungsemitter (1) einen Brechungsindex aufweist, der kleiner als der des transparenten Kerns (8) ist, um für eine innere Reflexion, bevorzugt innere Totalreflexion, von Strahlung innerhalb des transparenten Kerns (8) zu sorgen, um dadurch die Strahlung darin zu halten.

4. Thermophotovoltaiksystem (300) nach einem der vorhergehenden Ansprüche, wobei ein Spektralformer (3) zwischen dem Strahlungsemitter (1) und dem transparenten Kern (8) bereitgestellt ist, wobei der Spektralformer (3) ausgelegt ist als:
- ein Bandpassfilter für ein erstes, optimales Spektralband der Strahlung, die durch den Strahlungsemitter (1) emittiert wird, wenn dieser hoher Temperatur ausgesetzt wird; und/oder
- ein Reflektor für (ein) weitere(s) nichtoptimale(s) Spektralband/Spektralbänder der durch den Strahlungsemitter (1) emittierten Strahlung, sodass die Strahlung des zweiten, nichtoptimalen Spektralbands als Strahlung zurückgeführt wird, die auf den Strahlungsemitter (1) umgeleitet wird.

5. Thermophotovoltaiksystem (300) nach einem der vorhergehenden Ansprüche, wobei der transparente Kern (8) aus einem Material wie etwa SiO2, YAG (Yttrium-Aluminium-Granat) oder Yb hergestellt ist und/oder der transparente Kern (8) und/oder der Strahlungsemitter (1) mit einem seltene Erden enthaltenden Material, bevorzugt mit Ytterbium enthaltenden Material, ferner insbesondere mit Ytterbiumoxid Yb2O3, dotiert ist.

6. Thermophotovoltaiksystem (300) nach einem der vorhergehenden Ansprüche, wobei der mindestens eine Photovoltaikabschnitt (12) ein Faserabschnitt ist und/oder in einem anderen Abschnitt des Energieumwandlungs- und -übertragungsmediums (10) als einem katalytischen Abschnitt (2) bereitgestellt wird.

7. Thermophotovoltaiksystem (300) nach einem der vorhergehenden Ansprüche, umfassend eine Thermophotovoltaikvorrichtung (200) zum Umwandeln von chemischer Energie in Elektrizität, wobei die Thermophotovoltaikvorrichtung (200) eine Verbrennungs-, Wärmeaustausch- und Emittervorrichtung (100) zum Umwandeln von chemischer Energie in elektromagnetische Strahlung aufweist, wobei die Verbrennungs-, Wärmeaustausch- und Emittervorrichtung (100) ein Kammergehäuse (20) und das mindestens eine Energieumwandlungs- und -übertragungsmedium (10) und/oder die mindestens eine Photovoltaikzelle (30) oder einen Photovoltaikabschnitt (12) umfasst.

8. Thermophotovoltaiksystem (300) nach einem der vorhergehenden Ansprüche, umfassend mindestens einen Photovoltaikabschnitt (12), wobei entlang des/der Photovoltaikabschnitts/-e (12):
- der transparente Kern (8) längs durch eine strahlungsdurchlässige erste, insbesondere röhrenförmige, Elektrode (14) umgeben ist;
- die erste Elektrode (14) durch eine lichtempfindliche Schicht (16) bedeckt, insbesondere längs umgeben, ist; und
- die lichtempfindliche Schicht (16) durch eine zweite, insbesondere röhrenförmige, Elektrode (18) bedeckt, insbesondere längs umgeben, ist.

9. Thermophotovoltaiksystem (300) nach einem der vorhergehenden Ansprüche, umfassend mindestens einen Photovoltaikabschnitt (12), wobei innerhalb des/der Photovoltaikabschnitts/-e (12):
- eine strahlungsdurchlässige erste, insbesondere scheibenähnliche, Elektrode (15), insbesondere axial, angrenzend an den transparenten Kern (8) angeordnet ist;
- ein lichtempfindliches Element (17), insbesondere eine lichtempfindliche Scheibe, insbesondere axial, angrenzend an die erste Elektrode (15) angeordnet ist; und
- eine zweite, insbesondere scheibenähnliche, Elektrode (19), insbesondere axial, angrenzend an das lichtempfindliche Element (17) angeordnet ist.

10. Thermophotovoltaiksystem (300) nach einem der vorhergehenden Ansprüche, wobei der transparente Kern (8) mit einem Bragg-Filter (32), insbesondere Bragg-Gitter und/oder Faser-Bragg-Filter wirkverbunden ist, zum selektiven Auskoppeln der besagten hauptsächlich im nahen Infrarot emittierten Strahlung, insbesondere einer Strahlung mit einer Wellenlänge (λ) in einem Bereich von 0,5 µm bis 1,5 µm, insbesondere ungefähr 1 µm.

11. Thermophotovoltaiksystem (300) nach einem der vorhergehenden Ansprüche, das dazu ausgelegt ist, eine isochore und/oder adiabatische Verbrennung durchzuführen, und/oder dazu ausgelegt ist, Sauerstoff, insbesondere erwärmten Sauerstoff, der Wärmeübertragungskammer (22) auf intermittierende und/oder pulsförmige Weise zuzuführen.

12. Thermophotovoltaiksystem (300) nach einem der vorhergehenden Ansprüche, umfassend eine Kraftstoffquelle (50), die derart angeordnet ist, dass sie ein brennbares Kraftstoffgemisch aus der Kraftstoffquelle (50) zu der Wärmeübertragungskammer (22) leitet, wobei insbesondere die Kraftstoffquelle (50) eine chemische Energiequelle ist, wobei der chemische Energieträger ein fossiler oder synthetischer Kraftstoff wie etwa Methanol ist und/oder die Kraftstoffquelle (50) dazu ausgelegt ist, den Kraftstoff auf intermittierend und/oder pulsförmig zuzuführen.

13. Thermophotovoltaiksystem (300) nach einem der vorhergehenden Ansprüche, das als eine tragbare Energiequelle derart ausgelegt ist, dass sie gleichzeitig oder selektiv:
- als eine Wärmequelle wirkt, die Wärmestrahlung aus der thermischen Energiequelle (50) und/oder der Wärmeübertragungskammer (22) bereitstellt, und/oder;
- als eine Quelle für elektrische Energie wirkt, die elektrische Energie bereitstellt;
- als eine Lichtquelle an (einem) distalen Ende(n) des mindestens einen Energieumwandlungs- und -übertragungsmedium (10) wirkt, wobei der Strahlungsemitter (1) derart ausgelegt ist, dass er elektromagnetische Strahlung auch im sichtbaren Spektrum bereitstellt, wenn er hoher Temperatur ausgesetzt wird.

14. Modulares System (400), umfassend eine Vielzahl von Modulen (56), die jeweils das Thermophotovoltaiksystem (300) nach einem der vorhergehenden Ansprüche umfassen, wobei insbesondere die Module (56) miteinander verbunden sind über mindestens eines von:
- einer Photovoltaikzelle (30),
- einem ersten Einlass (51),
- einem zweiten Einlass (52),
- einem Zünder (53) und
- einem Auslass (54).

15. Modulares System (400) nach dem vorhergehenden Anspruch, wobei die gepulste Verbrennung in jedem Thermophotovoltaiksystem (300) individuell gesteuert wird, insbesondere durch ein gepulstes Zugeben von Sauerstoff zu einem zuvor eingespeisten Kraftstoff.

## Revendications

1. Système thermophotovoltaïque (300) comprenant :
- une chambre de transfert de chaleur (22), et
- au moins un milieu de transfert et de conversion d'énergie (10) qui comprend :
• un noyau transparent (8) pour le transfert d'énergie, et
• un matériau émetteur sélectif conçu pour émettre principalement un rayonnement dans le proche infrarouge lorsqu'il est chauffé à des températures élevées, dans lequel le noyau transparent (8) est dopé audit matériau émetteur sélectif et/ou dans lequel le milieu de transfert et de conversion d'énergie (10) comprend un émetteur de rayonnement (1), en particulier tubulaire, dopé audit matériau émetteur sélectif, le noyau transparent (8) étant agencé à l'intérieur dudit émetteur de rayonnement (1) et/ou entre au moins deux parties séparées dudit émetteur de rayonnement (1),
ledit au moins un milieu de transfert et de conversion d'énergie (10) étant agencé dans ladite chambre de transfert de chaleur (22) et étant couplé, de préférence couplé bout-à-bout, à au moins une cellule photovoltaïque (30) et/ou comprenant au moins une section photovoltaïque (12) qui est conçue pour convertir en électricité le rayonnement émis par l'émetteur de rayonnement (1),
le système thermophotovoltaïque (300) comprenant en outre une source de combustible (50) pour mettre en œuvre un processus de combustion dans ladite chambre de transfert de chaleur (22),
**caractérisé en ce que** le système thermophotovoltaïque (300) est conçu pour mettre en oeuvre le processus de combustion sous la forme d'une combustion puisée.

2. Système thermophotovoltaïque (300) selon la revendication 1, dans lequel une section catalytique (2) d'une surface extérieure dudit milieu de transfert et de conversion d'énergie (10), en particulier dudit émetteur de rayonnement (1), est agencée dans ladite chambre de transfert de chaleur (22) et/ou est au moins partiellement munie d'un revêtement catalytique afin de maximiser le transfert de chaleur entre un support d'énergie chimique et ladite section catalytique (2) et/ou pour fournir des réactions de surface, qui entraînent en particulier de la candoluminescence.

3. Système thermophotovoltaïque (300) selon la revendication 1 ou 2, dans lequel ledit milieu de transfert et de conversion d'énergie (10) est conçu sous la forme d'une fibre optique et/ou d'une tige optique comme une tige de verre, dans lequel en particulier l'émetteur de rayonnement (1) a un indice de réfraction inférieur au noyau transparent (8) de façon à fournir une réflexion interne, de préférence une réflexion interne totale, du rayonnement dans le noyau transparent (8) de façon à confiner ledit rayonnement à l'intérieur.

4. Système thermophotovoltaïque (300) selon l'une des revendications précédentes, dans lequel il est prévu un façonneur spectral (3) entre l'émetteur de rayonnement (1) et le noyau transparent (8), ledit façonneur spectral (3) étant conçu comme :
- un filtre passe-bande pour une première bande spectrale optimale du rayonnement émis par l'émetteur de rayonnement (1) lorsqu'elle est exposée à une température élevée ; et/ou
- un réflecteur pour (une) autre ou d'autres bande(s) spectrale(s) non optimale(s) du rayonnement émis par l'émetteur de rayonnement (1), de sorte que ledit deuxième rayonnement de bande spectrale non optimale est recyclé en rayonnement redirigé vers l'émetteur de rayonnement (1).

5. Système thermophotovoltaïque (300) selon l'une des revendications précédentes, dans lequel le noyau transparent (8) est constitué d'un matériau tel que Si02, YAG (grenat d'yttrium-aluminium) ou Yb et/ou dans lequel le noyau transparent (8) et/ou l'émetteur de rayonnement (1) est dopé avec un matériau contenant des terres rares, de préférence avec un matériau contenant de l'ytterbium, plus particulièrement avec de l'oxyde d'ytterbium Yb203.

6. Système thermophotovoltaïque (300) selon l'une des revendications précédentes, dans lequel ladite au moins une section photovoltaïque (12) est une section de fibre et/ou est prévue dans une section du milieu de transfert et de conversion d'énergie (10) autre qu'une section catalytique (2).

7. Système thermophotovoltaïque (300) selon l'une des revendications précédentes, comprenant un dispositif thermophotovoltaïque (200) pour convertir de l'énergie chimique en électricité, le dispositif thermophotovoltaïque (200) ayant un dispositif de combustion, d'échange de chaleur et un dispositif émetteur (100) pour convertir l'énergie chimique en rayonnement électromagnétique, le dispositif de combustion, d'échange de chaleur et émetteur (100) comprenant une enceinte de chambre (20) et le au moins un milieu de transfert et de conversion d'énergie (10) et/ou ladite au moins une cellule photovoltaïque (30) ou section photovoltaïque (12).

8. Système thermophotovoltaïque (300) selon l'une des revendications précédentes, comprenant au moins une section photovoltaïque (12), dans lequel le long de ladite ou desdites section(s) photovoltaïque(s) (12) :
- le noyau transparent (8) est entouré longitudinalement par une première électrode (14), en particulier tubulaire, transmettant le rayonnement ;
- la première électrode (14) est couverte, en particulier entourée longitudinalement, par une couche photosensible (16) ; et
- la couche photosensible (16) est couverte, en particulier entourée longitudinalement, par une deuxième électrode (18), en particulier tubulaire.

9. Système thermophotovoltaïque (300) selon l'une des revendications précédentes, comprenant au moins une section photovoltaïque (12), dans lequel, à l'intérieur de ladite ou desdites section(s) photovoltaïque(s) (12) :
- une première électrode (15), en particulier de type disque, transmettant le rayonnement est agencée de façon adjacente, en particulier axialement, par rapport au noyau transparent (8) ;
- un élément photosensible (17), en particulier un disque photosensible, est agencé de façon adjacente, en particulier axialement, par rapport à la première électrode (15) ;
et
- une deuxième électrode (19), en particulier de type disque, est agencée de façon adjacente, en particulier axialement, par rapport à l'élément photosensible (17).

10. Système thermophotovoltaïque (300) selon l'une des revendications précédentes, dans lequel le noyau transparent (8) est raccordé de façon opérationnelle à un filtre de bragg (32), en particulier un réseau de bragg et/ou un filtre à fibre de bragg, pour découpler de façon sélective ledit rayonnement proche infrarouge émis de façon prédominante, en particulier un rayonnement avec une longueur d'onde (λ) comprise dans une plage allant de 0,5 µm à 1,5 µm, en particulier d'approximativement 1 µm.

11. Système thermophotovoltaïque (300) selon l'une des revendications précédentes, conçu pour effectuer une combustion isochore et/ou adiabatique et/ou conçu pour amener de l'oxygène, en particulier de l'oxygène chauffé, dans la chambre de transfert de chaleur (22) par intermittence et/ou par impulsions.

12. Système thermophotovoltaïque (300) selon l'une des revendications précédentes, comprenant une source de combustible (50) agencée de façon à diriger un mélange de carburant combustible depuis la source de combustible (50) vers ladite chambre de transfert de chaleur (22), dans lequel en particulier ladite source de combustible (50) est une source d'énergie chimique, dans lequel le support d'énergie chimique est un combustible fossile ou synthétique comme du méthanol et/ou dans lequel ladite source de combustible (50) est conçue pour amener le combustible par intermittence et/ou par impulsions.

13. Système thermophotovoltaïque (300) selon l'une des revendications précédentes, conçu comme une source d'énergie portative de façon à pouvoir simultanément ou sélectivement :
- faire office de source de chaleur fournissant un rayonnement de chaleur depuis la source d'énergie thermique (50) et/ou la chambre de transfert de chaleur (22) et/ou ;
- faire office de source d'énergie électrique fournissant une énergie électrique ;
- faire office de source de lumière à une ou aux extrémités distales dudit au moins un milieu de transfert et de conversion d'énergie (10), l'émetteur de rayonnement (1) étant conçu de façon à fournir un rayonnement électromagnétique également dans le spectre visible lorsqu'il est exposé à une température élevée.

14. Système modulaire (400) comprenant une pluralité de modules (56), comprenant chacun le système thermophotovoltaïque (300) selon l'une des revendications précédentes, dans lequel en particulier les modules (56) sont interconnectés via au moins un des éléments suivants :
- une cellule photovoltaïque (30),
- une première arrivée (51),
- une deuxième arrivée (52),
- un allumeur (53), et
- un échappement (54).

15. Système modulaire (400) selon la revendication précédente, dans lequel la combustion pulsée dans chaque système thermophotovoltaïque (300) est commandée individuellement, en particulier par l'ajout pulsé d'oxygène à un combustible amené précédemment.
